# EUROPEAN PATENT SPECIFICATION

(11) **EP 4 531 524 B1**
(45) Date of publication and mention of the grant of the patent: **24.06.2026**
(21) Application number: 24199044.9
(22) Date of filing: 06.09.2024
(51) Int. Cl.: H10K 59/121, H10K 59/122, H10K 59/131, H10K 59/35, H10K 59/80

(54) **DISPLAY PANEL AND MANUFACTURING METHOD FOR THE SAME**
ANZEIGETAFEL UND HERSTELLUNGSVERFAHREN DAFÜR
PANNEAU D'AFFICHAGE ET SON PROCÉDÉ DE FABRICATION

(30) Priority: 26.09.2023 KR 20230129308
(43) Date of publication of application: 02.04.2025
(60) Divisional application: 26179607.2
(73) Proprietor: Samsung Display Co., Ltd., Yongin-si, Gyeonggi-do (KR)
(72) Inventor: YANG, Hee Jun, Yongin-si (KR); SUNG, Woo Yong, Yongin-si (KR); SONG, Seungyong, Yongin-si (KR); LEE, Jeongseok, Yongin-si (KR)
(74) Representative: Marks & Clerk LLP

(56) References cited:
- US-B2- 11 049 926
- US-B2- 11 665 920

## Description

### BACKGROUND

### 1. Field

The present invention relates to a display panel and a display panel manufacturing method, and more particularly, to a display panel with improved display quality.

### 2. Description of Related Art

Display devices, such as a television, a monitor, a smart phone, a tablet computer, and the like, which provide an image to a user include a display panel that displays an image. Various display panels, such as a liquid crystal display panel, an organic light emitting display panel, an electro wetting display panel, an electrophoretic display panel, and the like, are being developed. Display devices are disclosed in US 11 049 926 B2.

The organic light emitting display panel may include anodes, cathodes, and emission patterns. The emission patterns may be divided from one another for respective emissive regions, and the cathodes may provide a common voltage for the respective emissive regions.

### SUMMARY

Embodiments of the invention provide a display panel with improved display quality that includes light emitting elements formed without the use of a metal mask, and a method for manufacturing the display panel.

According to an embodiment, a display panel includes a base layer, a transistor disposed on the base layer, a common electrode disposed on the transistor, a conductive barrier wall that is disposed on the common electrode and that has a barrier wall opening, a barrier wall insulating layer disposed on the conductive barrier wall, and a light emitting element that is disposed on the barrier wall insulating layer and that includes a first electrode electrically connected to the transistor, an emission pattern disposed on the first electrode, and a second electrode disposed on the emission pattern and electrically connected with the conductive barrier wall.

In an embodiment, the conductive barrier wall may include a first barrier wall layer disposed on the common electrode and a second barrier wall layer disposed on the first barrier wall layer. The barrier wall opening may include a first region defined by the first barrier wall layer and a second region defined by the second barrier wall layer and integrally formed with the first region, and the first region may have a greater length in a first direction than the second region.

In an embodiment, the display panel may further include a pixel defining layer that is disposed on the barrier wall insulating layer and that has a light emitting opening that exposes at least a portion of the first electrode.

In an embodiment, the light emitting opening may not overlap the barrier wall opening.

In an embodiment, the emission pattern may cover a side surface of the second barrier wall layer, and the second electrode may cover an upper surface of the emission pattern and at least a portion of a side surface of the emission pattern.

In an embodiment, the display panel may further include an auxiliary electrode that covers the second electrode and a lower surface of the second barrier wall layer and that makes direct contact with the lower surface of the second barrier wall layer.

In an embodiment, the auxiliary electrode may make contact with a side surface of the first barrier wall layer.

In an embodiment, the display panel may further include a dummy auxiliary electrode that is spaced apart from the auxiliary electrode and that makes contact with a side surface of the first barrier wall layer.

In an embodiment, the display panel may further include a lower inorganic encapsulation pattern that covers an upper surface of the auxiliary electrode and that is spaced apart from the common electrode.

In an embodiment, the display panel may further include a light emitting contact hole that penetrates the conductive barrier wall and the common electrode and that overlaps the first electrode when viewed from above a plane.

In an embodiment, the first electrode may include a circular part and a protruding part that extends from one side of the circular part, and the light emitting contact hole may overlap the protruding part of the first electrode when viewed from above the plane.

In an embodiment, the first electrode may include a circular part, and the light emitting contact hole may overlap a center of the circular part when viewed from above the plane.

In an embodiment, the first electrode may be disposed between the second electrode and the common electrode.

According to an embodiment, a display panel includes a base layer, a conductive barrier wall that is disposed on the base layer and that has a barrier wall opening, a barrier wall insulating layer disposed on the conductive barrier wall, and a light emitting element including a first electrode disposed on the barrier wall insulating layer, an emission pattern that covers the first electrode and the barrier wall insulating layer, and a second electrode that covers the emission pattern and that is electrically connected with the conductive barrier wall. The barrier wall opening and the first electrode are spaced apart from each other when viewed from above a plane.

In an embodiment, the first electrode may overlap a center of the conductive barrier wall.

According to an embodiment, a method for manufacturing a display panel includes forming a common electrode and a circuit element layer including a transistor on a base layer, forming a preliminary conductive barrier wall on the common electrode, forming, on the preliminary conductive barrier wall, a preliminary barrier wall insulating layer, a first electrode, and a preliminary pixel defining layer that covers the first electrode, forming a light emitting opening that overlaps the first electrode, by etching the preliminary pixel defining layer, forming a conductive barrier wall, a barrier wall insulating layer, and a pixel defining layer by etching the preliminary conductive barrier wall, the preliminary barrier wall insulating layer, and the preliminary pixel defining layer, a barrier wall opening being defined in the conductive barrier wall, forming, on the conductive barrier wall, an emission pattern that covers the first electrode, and forming, on the emission pattern, a second electrode electrically connected with the conductive barrier wall. The light emitting opening and the barrier wall opening do not overlap each other when viewed from above a plane.

In an embodiment, the preliminary conductive barrier wall may include a first preliminary barrier wall layer disposed on the common electrode and a second preliminary barrier wall layer disposed on the first preliminary barrier wall layer. The forming of the conductive barrier wall, the barrier wall insulating layer, and the pixel defining layer may include firstly etching the preliminary conductive barrier wall, the preliminary barrier wall insulating layer, and the preliminary pixel defining layer and forming a first barrier wall layer and a second barrier wall layer by secondly etching the first preliminary barrier wall layer of the preliminary conductive barrier wall.

In an embodiment, the method may further include forming an auxiliary electrode that covers the second electrode and a lower surface of the second barrier wall layer.

In an embodiment, the auxiliary electrode may make contact with a side surface of the first barrier wall layer.

In an embodiment, the method may further include forming a lower inorganic encapsulation pattern that covers an upper surface of the auxiliary electrode, wherein the lower inorganic encapsulation patterns may be spaced apart from the common electrode.

In an embodiment, the method may further include forming a light emitting contact hole by etching the preliminary conductive barrier wall and the common electrode. The first electrode and the transistor may be electrically connected with each other through the light emitting contact hole.

In an embodiment, the forming of the preliminary barrier wall insulating layer, the first electrode, and the preliminary pixel defining layer that covers the first electrode on the preliminary conductive barrier wall may include forming the preliminary barrier wall insulating layer that covers an inner surface of the light emitting contact hole.

At least some of the above and other features of the invention are set out in the claims.

### BRIEF DESCRIPTION OF THE DRAWINGS

The above and other objects and features of the invention will become apparent by describing in detail embodiments thereof with reference to the accompanying drawings.
FIG. 1A is a perspective view of a display device, according to an embodiment.
FIG. 1B is an exploded perspective view of the display device, according to an embodiment.
FIG. 2 is a cross-sectional view of a display module, according to an embodiment.
FIG. 3 is a plan view of a display panel, according to an embodiment.
FIG. 4 is an enlarged plan view illustrating a portion of a display region of the display panel of FIG. 3, according to an embodiment.
FIG. 5 is a cross-sectional view of the display panel taken along line I-I' of FIG. 4, according to an embodiment.
FIG. 6 is a cross-sectional view of a portion of the display panel taken along line II-II' of FIG. 4, according to an embodiment.
FIG. 7 is a cross-sectional view of the display panel taken along line III-III' of FIG. 4, according to an embodiment.
FIG. 8 is a cross-sectional view of the display panel taken along line I-I' of FIG. 4, according to an embodiment.
FIG. 9 is a cross-sectional view of the display panel taken along line I-I' of FIG. 4, according to an embodiment.
FIG. 10A is an enlarged plan view illustrating a portion of a display region of a display panel, according to an embodiment.
FIG. 10B is a cross-sectional view of the display panel taken along line IV-IV' of FIG. 10A, according to an embodiment.
FIG. 11A is a cross-sectional view illustrating a step of a display panel manufacturing method, according to an embodiment.
FIG. 11B is a cross-sectional view illustrating a step of a display panel manufacturing method, according to an embodiment.
FIG. 11C is a cross-sectional view illustrating a step of a display panel manufacturing method, according to an embodiment.
FIG. 11D is a cross-sectional view illustrating a step of a display panel manufacturing method, according to an embodiment.
FIG. 11E is a cross-sectional view illustrating a step of a display panel manufacturing method, according to an embodiment.
FIG. 11F is a cross-sectional view illustrating a step of a display panel manufacturing method, according to an embodiment.
FIG. 11G is a cross-sectional view illustrating a step of a display panel manufacturing method, according to an embodiment.
FIG. 11H is a cross-sectional view illustrating a step of a display panel manufacturing method, according to an embodiment.
FIG. 11I is a cross-sectional view illustrating a step of a display panel manufacturing method, according to an embodiment.
FIG. 11J is a cross-sectional view illustrating a step of a display panel manufacturing method, according to an embodiment.
FIG. 11K is a cross-sectional view illustrating a step of a display panel manufacturing method, according to an embodiment.
FIG. 11L is a cross-sectional view illustrating a step of a display panel manufacturing method, according to an embodiment.
FIG. 12A is a cross-sectional view illustrating a step of the display panel manufacturing method, according to an embodiment.
FIG. 12B is a cross-sectional view illustrating a step of the display panel manufacturing method, according to an embodiment.
FIG. 12C is a cross-sectional view illustrating a step of the display panel manufacturing method, according to an embodiment.
FIG. 12D is a cross-sectional view illustrating a step of the display panel manufacturing method, according to an embodiment.

### DETAILED DESCRIPTION

Embodiments of the invention will be described below in more detail with reference to the accompanying drawings. The invention may, however, be embodied in different forms and should not be construed as limited to the embodiments set forth herein. Rather, these embodiments are provided so that this disclosure will be thorough and complete, and will fully convey the scope of the invention to those skilled in the art.

In this specification, when it is mentioned that a component (or, an area, a layer, a part, etc.) is referred to as being "on", "connected to" or "coupled to" another component, this means that the component may be directly on, connected to, or coupled to the other component or a third component may be present therebetween.

Identical reference numerals refer to identical components. Additionally, in the drawings, the thicknesses, proportions, and dimensions of components are exaggerated for effective description. As used herein, the term "and/or" includes all of one or more combinations defined by related components.

Terms such as first, second, and the like may be used to describe various components, but the components should not be limited by the terms. The terms may be used only for distinguishing one component from other components. For example, without departing the scope of the invention, a first component may be referred to as a second component, and similarly, the second component may also be referred to as the first component. The terms of a singular form may include plural forms unless otherwise specified.

In addition, terms such as "below", "under", "above", and "over" are used to describe a relationship of components illustrated in the drawings. The terms are relative concepts and are described based on directions illustrated in the drawing.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

Unless otherwise defined, all terms used herein, including technical or scientific terms, have the same meanings as those generally understood by those skilled in the art to which the invention pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

Hereinafter, embodiments of the invention will be described with reference to the accompanying drawings.

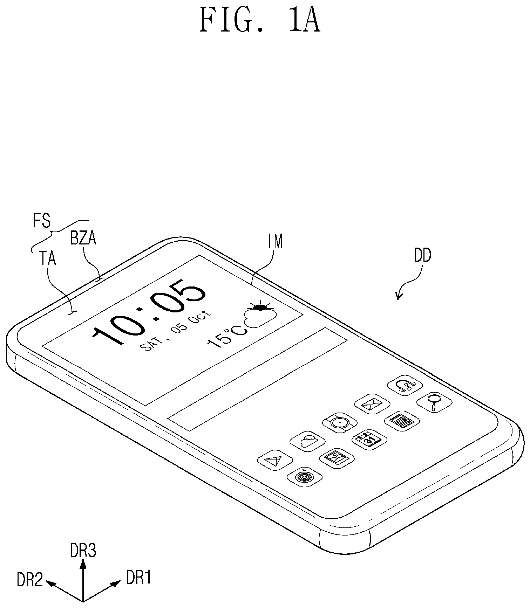

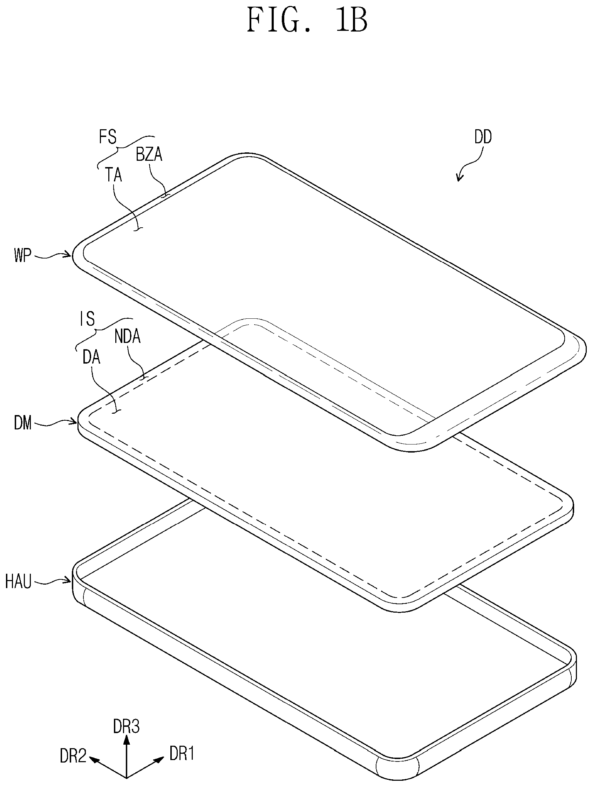

FIG. 1A is a perspective view of a display device DD, according to an embodiment. FIG. 1B is an exploded perspective view of the display device DD, according to an embodiment.

In an embodiment, the display device DD may be a large electronic device such as a television, a monitor, or a billboard. In another embodiment, the display device DD may be a small and medium-sized electronic device such as a personal computer, a notebook computer, a personal digital terminal, a car navigation unit, a game machine, a smart phone, a tablet computer, or a camera. However, this is only illustrative, and the display device DD may be employed as other display devices without departing from the scope of the invention. In FIGS. 1A and 1B, the display device DD is illustrated as a smart phone.

In an embodiment and referring to FIGS. 1A and 1B, the display device DD may display an image IM in a third direction DR3 on a display surface FS which is directed parallel to a first direction DR1 and a second direction DR2. The image IM may include a still image as well as a dynamic image. In FIG. 1A, a clock window and icons are illustrated as examples of the image IM. The display surface FS on which the image IM is displayed may correspond to the front surface of the display device DD.

In an embodiment, front surfaces (or, upper surfaces) and rear surfaces (or, lower surfaces) of members are defined based on the direction in which the image IM is displayed. The front surfaces and the rear surfaces may face away from each other in the third direction DR3, and the normal directions of the front surfaces and the rear surfaces may be directed parallel to the third direction DR3. Meanwhile, the directions indicated by the first to third directions DR1, DR2, and DR3, respectively, may be relative concepts and may be changed to other directions. As used herein, the expression "when viewed from above a plane" may mean that it is viewed in the third direction DR3.

In an embodiment, the display device DD may include a window WP, a display module DM, and a housing HAU. The window WP and the housing HAU may be coupled with each other to form the exterior of the display device DD.

In an embodiment, the window WP may include an optically clear insulating material. For example, the window WP may include glass or plastic. The front surface of the window WP may define the display surface FS of the display device DD. The display surface FS may include a transmissive region TA and a bezel region BZA. The transmissive region TA may be an optically clear region. For example, the transmissive region TA may be a region having a visible light transmittance of about 90% or more.

In an embodiment, the bezel region BZA may be a region having a lower light transmittance than the transmissive region TA. The bezel region BZA may define the shape of the transmissive region TA. The bezel region BZA may be disposed adjacent to the transmissive region TA and may surround the transmissive region TA. However, this is merely illustrative, and, in an embodiment, the bezel region BZA of the window WP may be omitted. The window WP may include at least one of an anti-fingerprint layer, a hard coating layer, or an anti-reflection layer and is not limited to any one embodiment.

In an embodiment, the display module DM may be disposed under the window WP. The display module DM may be a component that substantially generates the image IM. The image IM generated by the display module DM is displayed on a display surface IS of the display module DM and visually recognized by a user from the outside through the transmissive region TA.

In an embodiment, the display module DM may include a display region DA and a non-display region NDA. The display region DA may be a region activated depending on an electrical signal. The non-display region NDA may be disposed adjacent to the display region DA. The non-display region NDA may surround the display region DA. The non-display region NDA may be a region covered by the bezel region BZA and may not be visible from the outside.

In an embodiment, the housing HAU may be coupled with the window WP. The housing HAU may be coupled with the window WP to provide an inner space. The display module DM may be accommodated in the inner space.

In an embodiment, the housing HAU may include a material having a relatively high rigidity. For example, the housing HAU may include glass, plastic, or metal, or may include a plurality of frames and/or plates formed of a combination of the aforementioned materials. The housing HAU may stably protect components of the display device DD accommodated in the inner space from external impact.

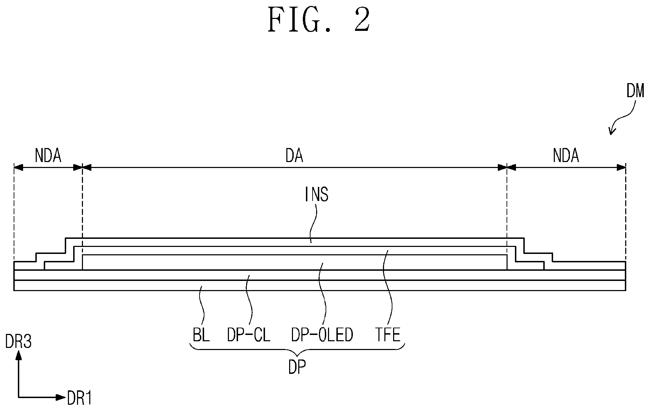

FIG. 2 is a cross-sectional view of the display module DM, according to an embodiment.

In an embodiment and referring to FIG. 2, the display module DM may include a display panel DP and an input sensor INS. Although not separately illustrated, the display device DD (refer to FIG. 1A), according to an embodiment, may further include a protective member disposed on the lower surface of the display panel DP or an anti-reflection member and/or a window member disposed on the upper surface of the input sensor INS.

In an embodiment, the display panel DP may be an emissive display panel. However, this is illustrative, and the invention is not limited thereto. For example, the display panel DP may be an organic light emitting display panel or an inorganic light emitting display panel. An emissive layer in the organic light emitting display panel may include an organic luminescent material. An emissive layer in the inorganic light emitting display panel may include quantum dots, quantum rods, or micro LEDs. Hereinafter, it will be exemplified that the display panel DP is an organic light emitting display panel.

In an embodiment, the display panel DP may include a base layer BL, a circuit element layer DP-CL, a display element layer DP-OLED, and a thin film encapsulation layer TFE that are disposed on the base layer BL. The input sensor INS may be directly disposed on the thin film encapsulation layer TFE. As used herein, the expression "component A is directly disposed on component B" means that an adhesive layer is not disposed between component A and component B.

In an embodiment, the base layer BL may include at least one plastic film. The base layer BL may be a flexible substrate and may include a plastic substrate, a glass substrate, a metal substrate, or an organic/inorganic composite substrate. The display region DA and the non-display region NDA described with reference to FIG. 1B may be identically defined in the base layer BL.

In an embodiment, the circuit element layer DP-CL may include at least one insulating layer and a circuit element. The insulating layer may include at least one inorganic layer and at least one organic layer. The circuit element includes signal lines and a pixel drive circuit.

In an embodiment, the display element layer DP-OLED may include a conductive barrier wall and a light emitting element. The light emitting element may include an anode, an intermediate layer, and a cathode.

In an embodiment, the thin film encapsulation layer TFE may include a plurality of thin films. Some of the thin films may be disposed to improve optical efficiency, and the other thin films may be disposed to protect organic light emitting diodes.

In an embodiment, the input sensor INS obtains coordinate information of an external input. The input sensor INS may have a multi-layer structure. The input sensor INS may include a single conductive layer or multiple conductive layers. In addition, the input sensor INS may include a single insulating layer or multiple insulating layers. The input sensor INS may sense the external input in a capacitive type. However, this is illustrative, and the invention is not limited thereto. For example, in an embodiment, the input sensor INS may sense the external input using an electromagnetic induction method or a pressure sensing method. Meanwhile, in another embodiment, the input sensor INS may be omitted.

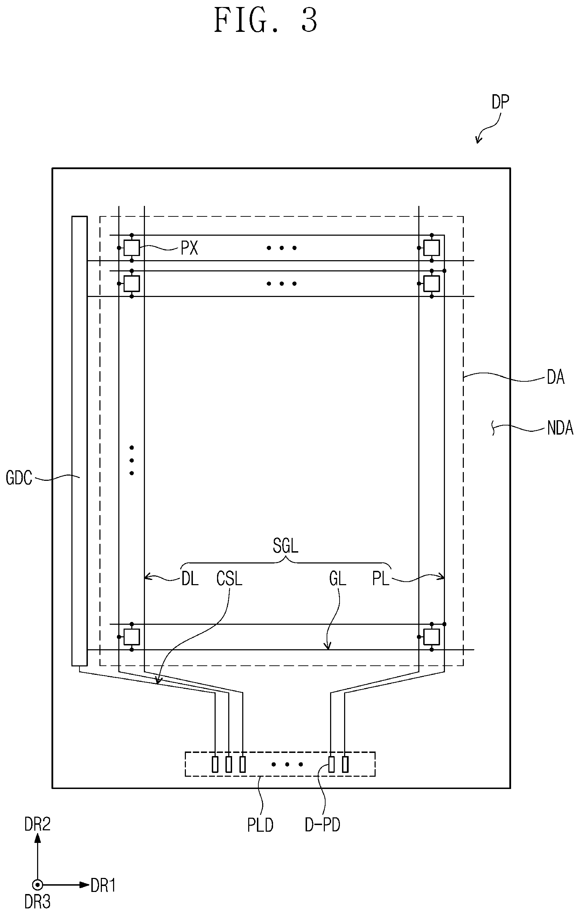

FIG. 3 is a plan view of the display panel, according to an embodiment.

In an embodiment and referring to FIG. 3, the display region DA and the non-display region NDA disposed around the display region DA may be defined in the display panel DP. The display panel DP may include pixels PX and signal lines SGL electrically connected to the pixels PX. The display panel DP may include a drive circuit GDC and a pad part PLD. The display region DA and the non-display region NDA may be distinguished from each other depending on where the pixels PX are disposed. The pixels PX may be disposed in the display region DA. The drive circuit GDC and the pad part PLD may be disposed in the non-display region NDA.

In an embodiment, the pixels PX may be arranged in the first direction DR1 and the second direction DR2. The pixels PX may include a plurality of pixel rows that extend in the first direction DR1 and that are arranged in the second direction DR2 and a plurality of pixel columns that extend in the second direction DR2 and that are arranged in the first direction DR1.

In an embodiment, the signal lines SGL may include gate lines GL, data lines DL, a power line PL, and a control signal line CSL. Each of the gate lines GL may be connected to a corresponding pixel among the pixels PX, and each of the data lines DL may be connected to a corresponding pixel among the pixels PX. The power line PL may be electrically connected to the pixels PX. The control signal line CSL may be connected to the drive circuit GDC and may provide control signals to the drive circuit GDC.

In an embodiment, the drive circuit GDC may include a gate drive circuit. The gate drive circuit may generate gate signals and may sequentially output the generated gate signals to the gate lines GL. The gate drive circuit may additionally output other control signals to the pixel drive circuit.

In an embodiment, the pad part PLD may be a part to which a flexible circuit board is connected. The pad part PLD may include pixel pads D-PD, and the pixel pads D-PD may be pads for connecting the flexible circuit board to the display panel DP. Each of the pixel pads D-PD may be connected with a corresponding signal line among the signal lines SGL. The pixel pads D-PD may be connected to the corresponding pixels PX through the signal lines SGL. Furthermore, one pixel pad among the pixel pads D-PD may be connected to the drive circuit GDC.

In addition, in an embodiment, the pad part PLD may further include input pads. The input pads may be pads for connecting a flexible circuit board to the input sensor INS (refer to FIG. 2). However, without being limited thereto, the input pads may be disposed on the input sensor INS (refer to FIG. 2) and may be connected with the pixel pads D-PD and a separate circuit board. In another embodiment, the input sensor INS (refer to FIG. 2) may be omitted, and the input pads may not be additionally included.

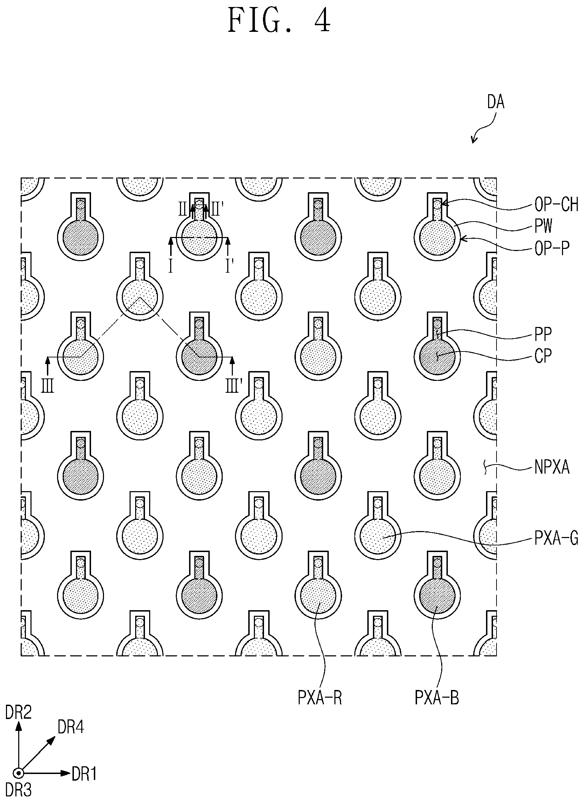

FIG. 4 is an enlarged plan view illustrating a portion of the display region DA (refer to FIG. 2) of the display panel DP (refer to FIG. 2), according to an embodiment. FIG. 4 is a plan view of the display module DM as viewed from above the display surface IS (refer to FIG. 1B) of the display module DM (refer to FIG. 1B) and illustrates an arrangement of emissive regions PXA-R, PXA-G, and PXA-B and a conductive barrier wall PW.

In an embodiment and referring to FIG. 4, the display region DA may include the emissive regions PXA-R, PXA-G, and PXA-B and a peripheral region NPXA surrounding the emissive regions PXA-R, PXA-G, and PXA-B. The emissive regions PXA-R, PXA-G, and PXA-B may correspond to regions through which light provided from light emitting elements is emitted. The first to third emissive regions PXA-R, PXA-G, and PXA-B, respectively, may be distinguished from one another depending on the colors of light emitted toward the outside of the display module DM (refer to FIG. 2).

In an embodiment, the first emissive region PXA-R, the second emissive region PXA-G and the third emissive region PXA-B may provide a first color light, a second color light, and a third color light, respectively, where each have different colors. For example, the first color light may be red light, the second color light may be green light, and the third color light may be blue light. However, examples of the first color light, the second color light, and the third color light are not necessarily limited thereto.

In an embodiment, the emissive regions PXA-R, PXA-G, and PXA-B may be defined as regions where the upper surfaces of anodes are exposed by light emitting openings that will be described below. The peripheral region NPXA may set the boundaries between the first to third emissive regions PXA-R, PXA-G, and PXA-B, respectively, and may prevent color mixing between the emissive regions PXA-R, PXA-G, and PXA-B.

In an embodiment, a plurality of first emissive regions PXA-R, a plurality of second emissive regions PXA-G, and a plurality of third emissive regions PXA-B may be provided. The plurality of first emissive regions PXA-R, the plurality of second emissive regions PXA-G, and the plurality of third emissive regions PXA-B may have a predetermined arrangement in the display region DA and may be repeatedly disposed. For example, the first and third emissive regions PXA-R and PXA-B, respectively, may be alternately arranged in the first direction DR1 to form a "first group". The second emissive regions PXA-G may be arranged in the first direction DR1 to form a "second group". The "first group" and the "second group" may be provided in plural numbers, and the "first groups" and the "second groups" may be alternately arranged in the second direction DR2.

In an embodiment, one second emissive region PXA-G may be spaced apart from one first emissive region PXA-R or one third emissive region PXA-B in a fourth direction DR4. The fourth direction DR4 may be defined as a direction between the first and second directions DR1 and DR2, respectively.

In an embodiment and referring to FIG. 4, the arrangement of the emissive regions PXA-R, PXA-G, and PXA-B is illustrated as an example, and without being limited thereto, the emissive regions PXA-R, PXA-G, and PXA-B may be arranged in various forms. In an embodiment, the emissive regions PXA-R, PXA-G, and PXA-B may have a PENTILE^{™} arrangement form as illustrated in FIG. 4. In another embodiment, the emissive regions PXA-R, PXA-G, and PXA-B may have a stripe arrangement form or a Diamond Pixel^{™} arrangement form.

In an embodiment, the emissive regions PXA-R, PXA-G, and PXA-B may have various shapes when viewed from above the plane. For example, the emissive regions PXA-R, PXA-G, and PXA-B may have a polygonal, circular, or oval shape. FIG. 4 illustrates the emissive regions PXA-R, PXA-G, and PXA-B that, when viewed from above the plane, have a shape including a circular part CP and a protruding part PP extending from one side of the circular part CP. Detailed description thereabout will be given below.

In an embodiment, when viewed from above the plane, the emissive regions PXA-R, PXA-G, and PXA-B may have the same shape, or at least some of the emissive regions PXA-R, PXA-G, and PXA-B may have different shapes. Although FIG. 4 illustrates an example that the emissive regions PXA-R, PXA-B, and PXA-G have the same shape when viewed from above the plane, the invention is not limited thereto. For example, in an embodiment, the first and third emissive regions PXA-R and PXA-B, respectively, may have the same shape when viewed from above the plane, and the second emissive region PXA-G may have a shape different from the shape of the first and third emissive regions PXA-R and PXA-B, respectively.

Although FIG. 4 illustrates an example that the emissive regions PXA-R, PXA-G, and PXA-B have the same area when viewed from above the plane, the invention is not limited thereto, and at least some of the emissive regions PXA-R, PXA-G, and PXA-B may have different areas when viewed from above the plane. In an embodiment, the area of the first emissive region PXA-R emitting red light may be greater than the area of the second emissive region PXA-G emitting green light and may be smaller than the area of the third emissive region PXA-B emitting blue light.

In an embodiment, the shapes, areas, and arrangement of the emissive regions PXA-R, PXA-G, and PXA-B of the display module DM (refer to FIG. 2) of the invention may be designed in various ways depending on the colors of emitted light or the size and configuration of the display module DM (refer to FIG.2) and are not limited to the embodiment illustrated in FIG. 4.

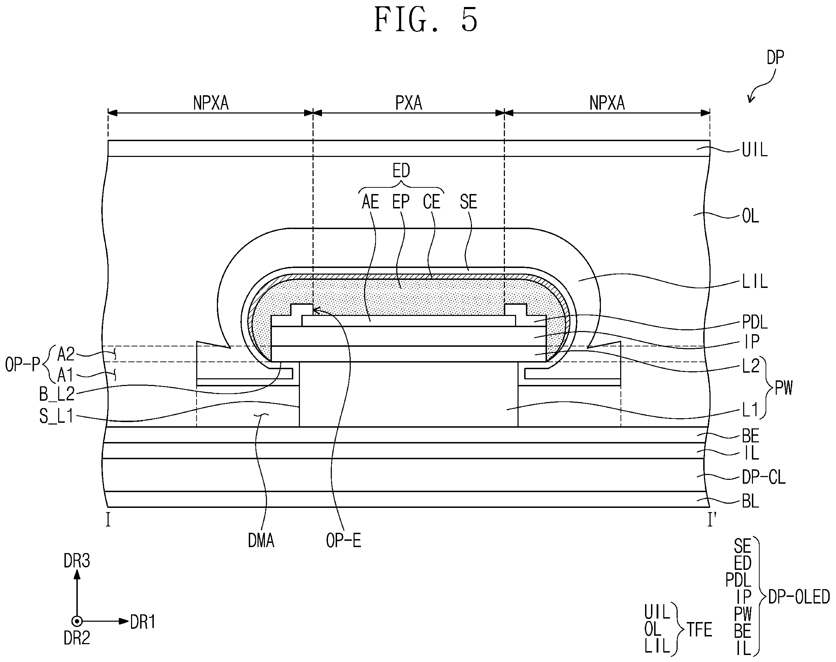

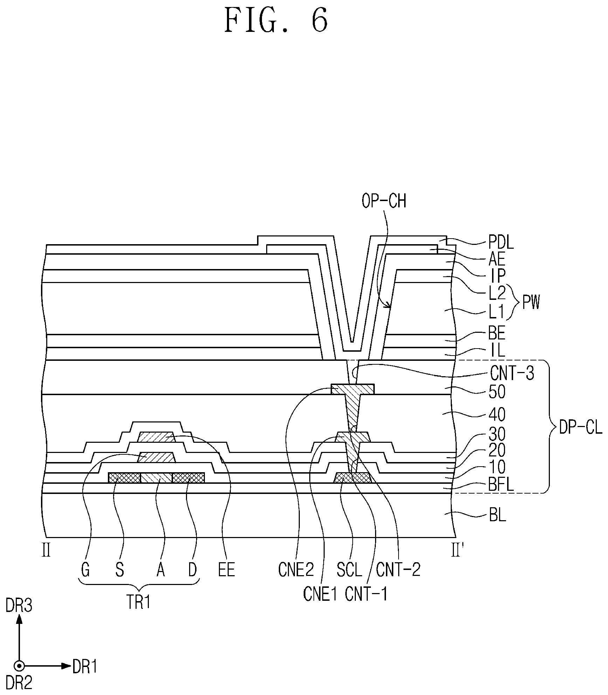

FIG. 5 is a cross-sectional view taken along line I-I' of FIG. 4, according to an embodiment. FIG. 6 is a cross-sectional view of a portion of the display panel taken along line II-II' of FIG. 4, according to an embodiment. In describing FIGS. 5 and 6, the description will be made with reference to FIG. 2, and descriptions of the same reference numerals will be omitted.

In an embodiment, FIG. 5 is a blowup of one emissive region PXA in the display region DA (refer to FIG. 4), and the emissive region PXA of FIG. 5 may correspond to one of the emissive regions PXA-R, PXA-G, and PXA-B of FIG. 4. In an embodiment, FIG. 6 is a blowup of a portion of the display region DA where a first electrode AE (or, an anode) is electrically connected with a transistor TR1. For convenience of description, FIG. 6 illustrates only a portion of the base layer BL, a portion of the circuit element layer DP-CL, and a portion of the display element layer DP-OLED.

In an embodiment and referring to FIGS. 5 and 6, the display panel DP may include the base layer BL, the circuit element layer DP-CL, the display element layer DP-OLED, and the thin film encapsulation layer TFE.

In an embodiment, the display panel DP may include a plurality of insulating layers, a semiconductor pattern, a conductive pattern, and a signal line. An insulating layer, a semiconductor layer, and a conductive layer are formed by coating, deposition, or the like. Thereafter, the insulating layer, the semiconductor layer, and the conductive layer may be selectively subjected to patterning by photolithography and etching. The semiconductor pattern, the conductive pattern, and the signal line included in the circuit element layer DP-CL and the display element layer DP-OLED may be formed by the above-described method.

In an embodiment, the circuit element layer DP-CL may be disposed on the base layer BL. The circuit element layer DP-CL may include a buffer layer BFL, the transistor TR1, a signal transmission region SCL, first to fifth insulating layers 10, 20, 30, 40, and 50, respectively, an electrode EE, and a plurality of connecting electrodes CNE1 and CNE2.

In an embodiment, the buffer layer BFL may be disposed on the base layer BL. The buffer layer BFL may improve the coupling force between the base layer BL and a semiconductor pattern. The buffer layer BFL may include silicon oxide layers and silicon nitride layers. The silicon oxide layers and the silicon nitride layers may be alternately stacked one above another.

In an embodiment, the semiconductor pattern may be disposed on the buffer layer BFL. The semiconductor pattern may include poly-silicon. However, without being limited thereto, the semiconductor pattern may include amorphous silicon or metal oxide. In FIG. 6, a portion of the semiconductor pattern is illustrated as an example, and the semiconductor pattern may be additionally disposed in the plurality of emissive regions PXA-R, PXA-G, PXA-B (refer to FIG. 4). The semiconductor pattern may be arranged across the plurality of emissive regions PXA-R, PXA-G, PXA-B according to a specific rule. The semiconductor pattern may have different electrical properties depending on whether the semiconductor pattern is doped or not. The semiconductor pattern may include a first region having a high doping concentration and a second region having a low doping concentration. The first region may be doped with an N-type dopant or a P-type dopant. A P-type transistor may include a first region doped with a P-type dopant.

In an embodiment, the first region has a higher conductivity than the second region and substantially serves as an electrode or a signal line. The second region may substantially correspond to an active (or, channel) region of the transistor. In other words, in an embodiment, one portion of the semiconductor pattern may be the active region of the transistor, another portion may be a source or drain of the transistor, and another portion may be a conductive region.

In an embodiment, the source S, the active region A, and the drain D of the transistor TR1 may be formed from the semiconductor pattern. A portion of the signal transmission region SCL formed from the semiconductor pattern is illustrated in FIG. 6. Although not separately illustrated, the signal transmission region SCL may be connected to the drain D of the transistor TR1 when viewed from above the plane.

In an embodiment, the first to fifth insulating layers 10, 20, 30, 40, and 50, respectively, may be disposed on the buffer layer BFL. The first to fifth insulating layers 10, 20, 30, 40, and 50, respectively, may be inorganic layers or organic layers.

In an embodiment, the first insulating layer 10 may be disposed on the buffer layer BFL. The first insulating layer 10 may cover the source S, the active region A, and the drain D of the transistor TR1 and the signal transmission region SCL that are disposed on the buffer layer BFL. A gate G of the transistor TR1 may be disposed on the first insulating layer 10. The second insulating layer 20 may be disposed on the first insulating layer 10 and may cover the gate G. The electrode EE may be disposed on the second insulating layer 20. The third insulating layer 30 may be disposed on the second insulating layer 20 and may cover the electrode EE.

In an embodiment, the first connecting electrode CNE1 may be disposed on the third insulating layer 30. The first connecting electrode CNE1 may be connected to the signal transmission region SCL through a contact hole CNT-1 penetrating the first to third insulating layers 10, 20, and 30, respectively. The fourth insulating layer 40 may be disposed on the third insulating layer 30 and may cover the first connecting electrode CNE1. The fourth insulating layer 40 may be an organic layer.

In an embodiment, the second connecting electrode CNE2 may be disposed on the fourth insulating layer 40. The second connecting electrode CNE2 may be connected to the first connecting electrode CNE1 through a contact hole CNT-2 penetrating the fourth insulating layer 40. The fifth insulating layer 50 may be disposed on the fourth insulating layer 40 and may cover the second connecting electrode CNE2. The fifth insulating layer 50 may be an organic layer. A contact hole CNT-3 penetrating the fifth insulating layer 50 may be defined in the fifth insulating layer 50. The first electrode AE, which will be described below, may be connected to the second connecting electrode CNE2 through the contact hole CNT-3.

In an embodiment, the display element layer DP-OLED may be disposed on the circuit element layer DP-CL. The display element layer DP-OLED may include an insulating layer IL, a common electrode BE, the conductive barrier wall PW, a barrier wall insulating layer IP, a light emitting element ED, and an auxiliary electrode SE.

In an embodiment, the insulating layer IL may be disposed on the circuit element layer DP-CL. In detail, the insulating layer IL may be disposed on the fifth insulating layer 50 and may cover the fifth insulating layer 50. The insulating layer IL may define a portion of a light emitting contact hole OP-CH. Referring to FIG. 6, the light emitting contact hole OP-CH may be an opening through which the first electrode AE is connected to the second connecting electrode CNE2.

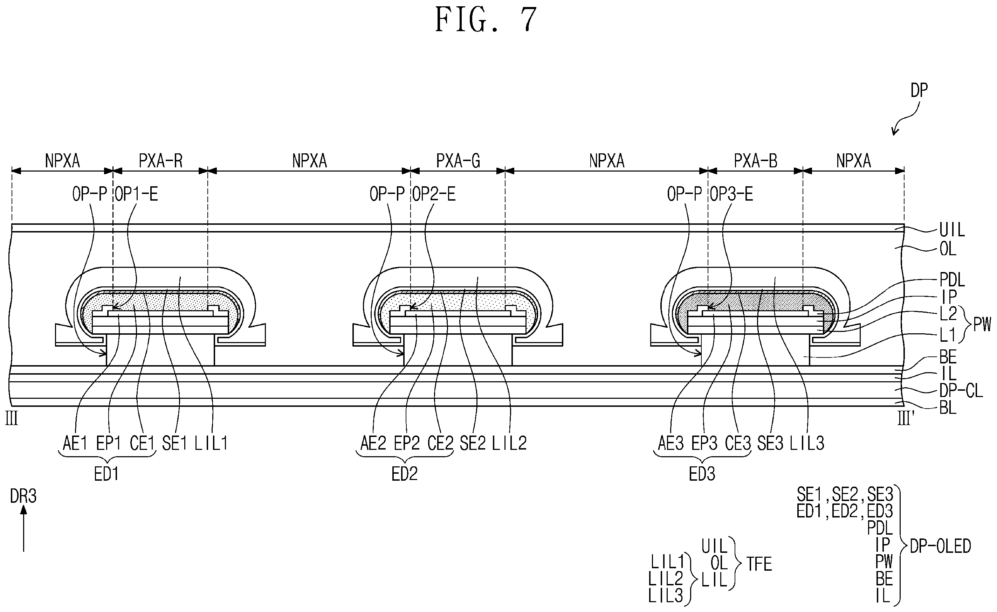

In an embodiment, the common electrode BE may be disposed on the insulating layer IL. For example, the common electrode BE may be disposed over the transistor TR1 of the circuit element layer DP-CL. The common electrode BE may be commonly disposed in the entire display region DA (refer to FIG. 4) and may provide a common voltage. For example, the common electrode BE may be disposed to overlap all of the first to third emissive regions PXA-R, PXA-G, and PXA-B, respectively, (refer to FIG. 7). Referring to FIG. 6, the common electrode BE may define a portion of the light emitting contact hole OP-CH.

In an embodiment, the conductive barrier wall PW may be disposed on the common electrode BE. The conductive barrier wall PW may have a barrier wall opening OP-P (or, the barrier wall opening OP-P may be defined in the conductive barrier wall PW). The barrier wall opening OP-P may not overlap a light emitting opening OP-E that will be described below. Referring to FIG. 6, the conductive barrier wall PW may define a portion of the light emitting contact hole OP-CH.

In an embodiment, the conductive barrier wall PW may have an undercut shape. The conductive barrier wall PW may include multiple layers sequentially stacked one above another, and at least one layer among the multiple layers may be recessed when compared to the other layers. Accordingly, the conductive barrier wall PW may include a tip portion.

In an embodiment, the conductive barrier wall PW may include a first barrier wall layer L1 and a second barrier wall layer L2. The first barrier wall layer L1 may be disposed on the common electrode BE, and the second barrier wall layer L2 may be disposed on the first barrier wall layer L1. As illustrated in FIGS. 5 and 6, the thickness of the first barrier wall layer L1 may be greater than the thickness of the second barrier wall layer L2. However, the invention is not limited thereto.

In an embodiment, the first barrier wall layer L1 may be relatively recessed with respect to the emissive region PXA when compared to the second barrier wall layer L2. The first barrier wall layer L1 may be undercut with respect to the second barrier wall layer L2. The portion of the second barrier wall layer L2 that protrudes from the first barrier wall layer L1 toward the center of the barrier wall opening OP-P may be defined as the tip portion in the conductive barrier wall PW.

In an embodiment, the barrier wall opening OP-P defined in the conductive barrier wall PW may include a first region A1 defined by the first barrier wall layer L1 and a second region A2 defined by the second barrier wall layer L2. The second region A2 may be integrally formed with the first region A1. That is, the first region A1 and the second region A2 may be openings integrally formed with each other. The width of the first region A1 may be different from the width of the second region A2. That is, the length of the first region A1 in the first direction DR1 may be greater than the length of the second region A2 in the first direction DR1. In this case, the second region A2 of the barrier wall opening OP-P may be a region that defines the tip portion. That is, due to the protruding tip portion, the second region A2 may have a narrower width than the first region A1.

In an embodiment, each of the first barrier wall layer L1 and the second barrier wall layer L2 may include a conductive material. For example, the conductive material may include metal, transparent conductive oxide (TCO), or a combination thereof. For example, the metal may include gold (Au), silver (Ag), aluminium (Al), magnesium (Mg), lithium (Li), molybdenum (Mo), titanium (Ti), copper (Cu), or an alloy. The transparent conductive oxide may include indium tin oxide (ITO), indium zinc oxide (IZO), zinc oxide, indium oxide, indium gallium oxide, indium gallium zinc oxide (IGZO), or aluminium zinc oxide. In an embodiment, the second barrier wall layer L2 may include the same material as the common electrode BE, and the first barrier wall layer L1 and the second barrier wall layer L2 may include different materials. However, this is merely illustrative, and the invention is not limited thereto.

In an embodiment, although FIG. 5 illustrates an example that the inner surfaces of the conductive barrier wall PW are directed perpendicular to the upper surface of the common electrode BE, the invention is not limited thereto. For example, in another embodiment, the conductive barrier wall PW may have a tapered shape or an inverted tapered shape.

In an embodiment and referring to FIGS. 4 and 5, the barrier wall opening OP-P and the anode AE may be spaced apart from each other when viewed from above the plane. That is, the barrier wall opening OP-P and the anode AE may be formed so as not to overlap each other when viewed from above the plane. The anode AE may overlap the center of the conductive barrier wall PW.

In an embodiment, the barrier wall insulating layer IP may be disposed on the conductive barrier wall PW. The barrier wall insulating layer IP disposed on the conductive barrier wall PW may prevent electrical connection between the conductive barrier wall PW and the first electrode AE. Referring to FIG. 6, the barrier wall insulating layer IP may cover the side surfaces of the conductive barrier wall PW, the common electrode BE, and the insulating layer IL that define the light emitting contact hole OP-CH.

In an embodiment, the light emitting element ED may include the anode AE (or, the first electrode), an emission pattern EP, and a cathode CE (or, a second electrode).

In an embodiment, the anode AE may be disposed on the barrier wall insulating layer IP. The anode AE may be disposed between the common electrode BE and the cathode CE that will be described below. The anode AE disposed on the barrier wall insulating layer IP may make contact with the upper surface of the contact hole CNT-3 that is not covered by the barrier wall insulating layer IP and may be connected to the second connecting electrode CNE2. Accordingly, the anode AE may be electrically connected to the signal transmission region SCL through the first and second connecting electrodes CNE1 and CNE2, respectively, and may be electrically connected to a corresponding circuit element (e.g., the transistor TR1).

In an embodiment, the anode AE may be a transmissive electrode, a transflective electrode, or a reflective electrode. The anode AE may include a single-layer structure or a multi-layer structure. The anode AE may include a plurality of layers including ITO and Ag. For example, in an embodiment, the anode AE may include a layer including ITO (hereinafter, referred to as the lower ITO layer), a layer disposed on the lower ITO layer and including Ag (hereinafter, referred to as the Ag layer), and a layer disposed on the Ag layer and including ITO (hereinafter, referred to as the upper ITO layer).

In an embodiment, the emission pattern EP may be disposed on the anode AE. The emission pattern EP may include an emissive layer including a luminescent material. The emission pattern EP may further include a hole injection layer (HIL) and a hole transport layer (HTL) that are disposed between the anode AE and the emissive layer and may further include an electron transport layer (ETL) and an electron injection layer (EIL) that are disposed on the emissive layer. The emission pattern EP may be referred to as an "organic layer" or an "intermediate layer".

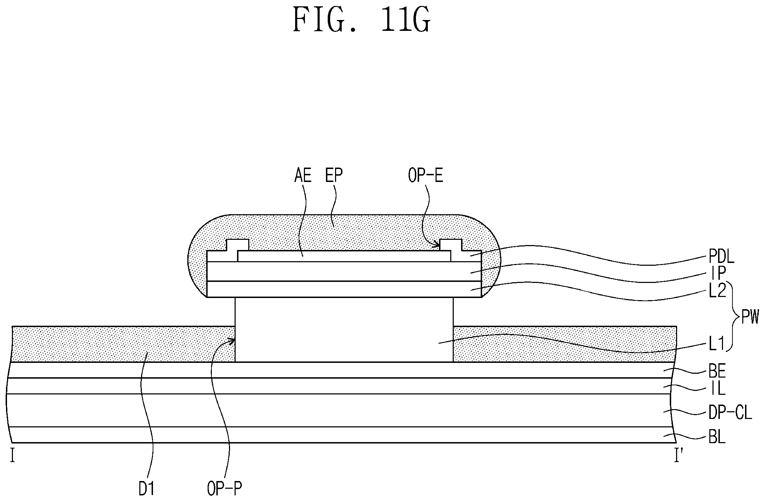

In an embodiment, the emission pattern EP may be subjected to patterning by the tip portion defined in the conductive barrier wall PW. The emission pattern EP may be formed to cover the side surface of the second barrier wall layer L2. For example, in an embodiment, the emissive layer may be subjected to patterning by the tip portion defined in the conductive barrier wall PW and may form the emission pattern EP that covers the side surface of the barrier wall insulating layer IP and the side surface of the second barrier wall L2 and a first dummy layer D1 (refer to FIG. 11G) that is disposed on the common electrode BE.

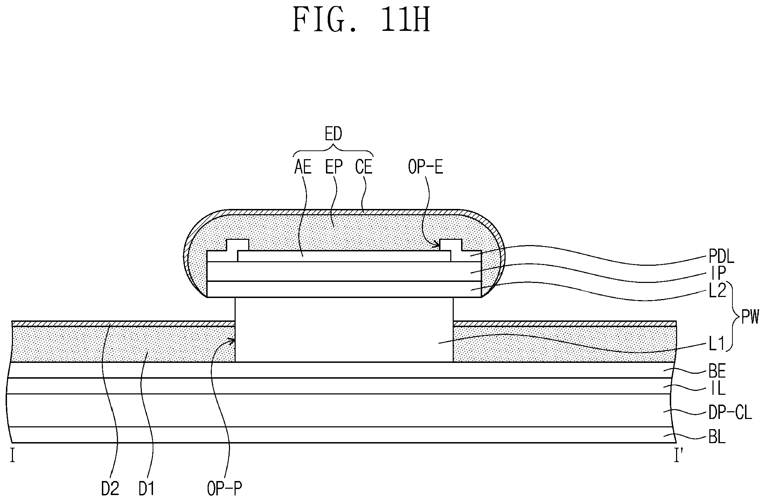

In an embodiment, the cathode CE may be disposed on the emission pattern EP. The cathode CE may be subjected to patterning by the tip portion defined in the conductive barrier wall PW. The cathode CE may cover the upper surface of the emission pattern EP and at least a portion of the side surface of the emission pattern EP. For example, a cathode layer may be subjected to patterning by the tip portion defined in the conductive barrier wall PW and may form the cathode CE that covers the upper surface of the emission pattern EP and at least a portion of the side surface of the emission pattern EP and a second dummy layer D2 (refer to FIG. 11H) that is disposed on the first dummy layer D1 (refer to FIG. 11G).

In an embodiment, the cathode CE may include a conductive material. As long as the cathode CE is capable of having conductivity, the cathode CE may be formed of various materials such as metal, transparent conductive oxide (TCO), or a conductive polymer material. For example, in an embodiment, the cathode CE may include silver (Ag), magnesium (Mg), lead (Pb), copper (Cu), or a compound thereof. The cathode CE may be electrically connected with the conductive barrier wall PW. Detailed description thereabout will be given below.

In an embodiment, the auxiliary electrode SE may be disposed on the cathode CE. The auxiliary electrode SE may cover the cathode CE and may cover the lower surface B_L2 of the second barrier wall layer L2 by making direct contact with the lower surface B_L2 of the second barrier wall layer L2. For example, the auxiliary electrode SE may cover the cathode CE and may extend along the lower surface of the second barrier wall layer L2 and the side surface S_L1 of the first barrier wall layer L1. That is, the auxiliary electrode SE may make contact with the side surface S_L1 of the first barrier wall layer L1. However, this is illustrative, and the shape of the auxiliary electrode SE is not limited to the above example.

In an embodiment, the auxiliary electrode SE may include a conductive material. For example, the conductive material may include metal, transparent conductive oxide (TCO), or a combination thereof. For example, in an embodiment, the metal may include gold (Au), silver (Ag), aluminium (Al), magnesium (Mg), lithium (Li), molybdenum (Mo), titanium (Ti), copper (Cu), or an alloy. The transparent conductive oxide may include indium tin oxide (ITO), indium zinc oxide (IZO), zinc oxide, indium oxide, indium gallium oxide, indium gallium zinc oxide (IGZO), or aluminium zinc oxide.

In an embodiment, the auxiliary electrode SE may electrically connect the cathode CE and the conductive barrier wall PW by making contact with the cathode CE and the conductive barrier wall PW. The conductive barrier wall PW may receive a drive voltage (or, a bias voltage), and the cathode CE may receive the drive voltage (or, the bias voltage) accordingly.

In an embodiment, the display element layer DP-OLED may further include a pixel defining layer PDL. The pixel defining layer PDL may be disposed on the barrier wall insulating layer IP. The pixel defining layer PDL may have the light emitting opening OP-E that exposes at least a portion of the anode AE (or, the light emitting opening OP-E that exposes at least a portion of the anode AE may be defined in the pixel defining layer PDL). The light emitting opening OP-E may overlap (or, correspond to) the anode AE, and the pixel defining layer PDL may expose at least a portion of the anode AE through the light emitting opening OP-E. The pixel defining layer PDL may include an inorganic insulating material. For example, the pixel defining layer PDL may include silicon nitride SiNₓ.

In an embodiment and referring to FIG. 5, the thin film encapsulation layer TFE may be disposed on the display element layer DP-OLED. The thin film encapsulation layer TFE may include a lower inorganic encapsulation pattern LIL, an organic encapsulation film OL, and an upper inorganic encapsulation film UIL.

In an embodiment, the lower inorganic encapsulation pattern LIL may be formed to correspond to (or, overlap) the light emitting opening OP-E or the conductive barrier wall PW. The lower inorganic encapsulation pattern LIL may be disposed on the auxiliary electrode SE and may cover the upper surface of the auxiliary electrode SE. The lower inorganic encapsulation pattern LIL may be spaced part from the common electrode BE. The space by which the lower inorganic encapsulation pattern LIL and the common electrode BE are spaced apart from each other, as shown in the cross-sectional view of FIG. 5, may be defined as a dummy region DMA.

In an embodiment, the organic encapsulation film OL may be disposed on the lower inorganic encapsulation pattern LIL to cover the lower inorganic encapsulation pattern LIL and may provide a flat upper surface. A portion of the organic encapsulation film OL may fill the dummy region DMA. However, the shape of the organic encapsulation film OL is illustrative, and the invention is not limited thereto. For example, in an embodiment, the organic encapsulation film OL may not fill the dummy region DMA, and the dummy region DMA may remain as an empty space.

In an embodiment, the upper inorganic encapsulation film UIL may be disposed on the organic encapsulation film OL. The upper inorganic encapsulation film UIL may include an inorganic material.

In an embodiment, the lower inorganic encapsulation pattern LIL and the upper inorganic encapsulation film UIL may protect the display element layer DP-OLED from moisture/oxygen, and the organic encapsulation film OL may protect the display element layer DP-OLED from foreign matter such as dust particles.

In an embodiment and referring to FIGS. 4 and 5, the circular parts CP of the emissive regions PXA-R, PXA-G, and PXA-B may be regions through which light provided from the light emitting elements is emitted. The protruding parts PP of the emissive regions PXA-R, PXA-G, and PXA-B may overlap the light emitting contact holes OP-CH. The light emitting contact hole OP-CH may be defined to penetrate the conductive barrier wall PW, the common electrode BE, and the insulating layer IL, and the first electrode AE may be electrically connected with the corresponding transistor TR1 through the light emitting contact hole OP-CH. The light emitting contact hole OP-CH may overlap the first electrode AE when viewed from above the plane.

In an embodiment, a display panel according to a comparative example may include a light emitting element formed in a barrier wall opening of a conductive barrier wall and may include a lower inorganic encapsulation pattern that has a cantilever shape and covers the light emitting element.

According to an embodiment, since the light emitting element ED is formed on the conductive barrier wall PW rather than in the barrier wall opening OP-P of the conductive barrier wall PW, an occurrence of a shadow region may be prevented in a deposition process. Accordingly, the invention may provide a display panel DP that facilitates implementing high resolution. In addition, since the lower inorganic encapsulation pattern LIL covering the light emitting element ED formed on the conductive barrier wall PW is more stable and robust and the light emitting element ED is not disposed in the barrier wall opening OP-P, the thickness of the conductive barrier wall PW may be decreased.

FIG. 7 is a cross-sectional view taken along line III-III' of FIG. 4, according to an embodiment. FIG. 7 is an enlarged view illustrating one first emissive region PXA-R, one second emissive region PXA-G, and one third emissive region PXA-B, and the description of the emissive region PXA of FIG. 5 may be identically applied to each of the emissive regions PXA-R, PXA-G, and PXA-B of FIG. 7, according to an embodiment.

In an embodiment and referring to FIG. 7, the display panel DP may include the base layer BL, the circuit element layer DP-CL, the display element layer DP-OLED, and the thin film encapsulation layer TFE. The display element layer DP-OLED may include the insulating layer IL, the common electrode BE, the conductive barrier wall PW, the barrier wall insulating layer IP, the pixel defining layer PDL, first to third light emitting elements ED1, ED2, and ED3, respectively, and first to third auxiliary electrodes SE1, SE2, and SE3, respectively.

In an embodiment, the light emitting elements ED1, ED2, and ED3 may include the first light emitting element ED1, the second light emitting element ED2, and the third light emitting element ED3. The first light emitting element ED1 may include a first anode AE1, a first emission pattern EP1, and a first cathode CE1. The second light emitting element ED2 may include a second anode AE2, a second emission pattern EP2, and a second cathode CE2. The third light emitting element ED3 may include a third anode AE3, a third emission pattern EP3, and a third cathode CE3. The first to third anodes AE1, AE2, and AE3, respectively, may be provided in a plurality of patterns. In an embodiment, the first emission pattern EP1 may provide red light, the second emission pattern EP2 may provide green light, and the third emission pattern EP3 may provide blue light.

In an embodiment, the display element layer DP-OLED may further include the pixel defining layer PDL. The pixel defining layer PDL may be disposed on the barrier wall insulating layer IP. First to third light emitting openings OP1-E, OP2-E, and OP3-E, respectively, may be defined in the pixel defining layer PDL. The first light emitting opening OP1-E may expose at least a portion of the first anode AE1. The second light emitting opening OP2-E may expose at least a portion of the second anode AE2. The third light emitting opening OP3-E may expose at least a portion of the third anode AE3.

In an embodiment, the first emissive region PXA-R may be defined as a region of the upper surface of the first anode AE1 exposed by the first light emitting opening OP1-E. The second emissive region PXA-G may be defined as a region of the upper surface of the second anode AE2 exposed by the second light emitting opening OP2-E. The third emissive region PXA-B may be defined as a region of the upper surface of the third anode AE3 exposed by the third light emitting opening OP3-E.

In an embodiment, barrier wall openings OP-P that do not overlap the first to third light emitting openings OP1-E, OP2-E, and OP3-E, respectively, may be defined in the conductive barrier wall PW. The barrier wall openings OP-P may not overlap the anodes AE1, AE2, and AE3. The barrier wall openings OP-P may overlap the peripheral region NPXA surrounding the emissive regions PXA-R, PXA-G, and PXA-B. Each of the barrier wall openings OP-P may include the first region A1 (refer to FIG. 5) and the second region A2 (refer to FIG. 5) described above with reference to FIG. 5.

In an embodiment, the emission patterns EP1, EP2, and EP3 may be physically divided from one another by the second barrier wall L2 that forms tip portions and that may cover the side surfaces of the second barrier wall layer L2. In addition, the first to third cathodes CE1, CE2, and CE3, respectively, may be physically divided from one another by the second barrier wall L2 that forms the tip portions and that may cover the upper surfaces of the corresponding emission patterns EP1, EP2, and EP3 and at least portions of the side surfaces of the corresponding emission patterns EP1, EP2, and EP3.

According to an embodiment, a plurality of first emission patterns EP1 may be subjected to patterning and deposited in pixel units by the tip portions defined in the conductive barrier wall PW. That is, the first emission patterns EP1 may be commonly formed using an open mask, but may be easily divided from one another in pixel units by the conductive barrier wall PW.

In contrast, when the first emission patterns EP1 are subjected to patterning using a fine metal mask (FMM), a spacer for support that protrudes from the conductive barrier wall has to be provided to support the fine metal mask. Furthermore, the fine metal mask may be spaced, by the height of the barrier wall and the spacer, apart from a base surface on which the patterning is performed, and therefore there may be a limitation in the implementation of high resolution. In addition, since the fine metal mask is brought into contact with the spacer, foreign matter may remain on the spacer after the patterning process of the first emission patterns EP1, or the spacer may be damaged by a dent in the fine metal mask. Accordingly, a defective display panel may be formed.

According to an embodiment, since the conductive barrier wall PW is included, the physical separation between the light emitting elements ED1, ED2, and ED3 may be easily achieved. Accordingly, current leakage or a driving error between adjacent emissive regions PXA-R, PXA-G, and PXA-B may be prevented, and the light emitting elements ED1, ED2, and ED3 may be independently driven.

In an embodiment, by making the plurality of first emission patterns EP1 subject to patterning without a mask in contact with an internal component in the display region DA (refer to FIG. 1B), a defect rate may be reduced, and thus the display panel DP with improved process reliability may be provided. Since the patterning is possible even without the separate spacer for support that protrudes from the conductive barrier wall PW, the areas of the emissive regions PXA-R, PXA-G, and PXA-B may be scaled down, and thus the display panel DP capable of easily implementing high resolution may be provided.

In an embodiment, in the manufacture of the large-area display panel DP, the manufacture of a large-area mask may be omitted. Accordingly, process costs may be reduced, and the display panel DP may not be affected by defects that are likely to occur in the large-area mask. Thus, the display panel DP with improved process reliability may be provided. The description of the plurality of first emission patterns EP1 may be identically applied to a plurality of second emission patterns EP2 and a plurality of third emission patterns EP3.

In an embodiment, the auxiliary electrodes SE1, SE2, and SE3 may include the first auxiliary electrode SE1, the second auxiliary electrode SE2, and the third auxiliary electrode SE3. The first auxiliary electrode SE1 may cover the first cathode CE1, the second auxiliary electrode SE2 may cover the second cathode CE2, and the third auxiliary electrode SE3 may cover the third cathode CE3. The auxiliary electrodes SE1, SE2, and SE3 may cover the lower surfaces B_L2 (See FIG. 5) of the second barrier wall layer L2 by making direct contact with the lower surfaces B_L2 of the second barrier wall layer L2.

In an embodiment, the first auxiliary electrode SE1 may electrically connect the first cathode CE1 and the conductive barrier wall PW by making contact with the first cathode CE1 and the conductive barrier wall PW. The conductive barrier wall PW may receive a drive voltage (or, a bias voltage), and the first cathode CE1 may receive the drive voltage (or, the bias voltage) accordingly. The second auxiliary electrode SE2 may electrically connect the second cathode CE2 and the conductive barrier wall PW by making contact with the second cathode CE2 and the conductive barrier wall PW. The conductive barrier wall PW may receive the drive voltage (or, the bias voltage), and the second cathode CE2 may receive the drive voltage (or, the bias voltage) accordingly. The third auxiliary electrode SE3 may electrically connect the third cathode CE3 and the conductive barrier wall PW by making contact with the third cathode CE3 and the conductive barrier wall PW. The conductive barrier wall PW may receive the drive voltage (or, the bias voltage), and the third cathode CE3 may receive the drive voltage (or, the bias voltage) accordingly.

In an embodiment, the thin film encapsulation layer TFE may include lower inorganic encapsulation patterns LIL1, LIL2, and LIL3, the organic encapsulation film OL, and the upper inorganic encapsulation film UIL.

In an embodiment, the lower inorganic encapsulation patterns LIL1, LIL2, and LIL3 may include the first lower inorganic encapsulation pattern LIL1, the second lower inorganic encapsulation pattern LIL2, and the third lower inorganic encapsulation pattern LIL3. The lower inorganic encapsulation patterns LIL1, LIL2, and LIL3 may be spaced apart from the common electrode BE.

In an embodiment, the first lower inorganic encapsulation pattern LIL1 may be formed to correspond to (or, overlap) the first light emitting opening OP1-E or the conductive barrier wall PW. The first lower inorganic encapsulation pattern LIL1 may be disposed on the first auxiliary electrode SE1 and may cover the upper surface of the first auxiliary electrode SE1.

In an embodiment, the second lower inorganic encapsulation pattern LIL2 may be formed to correspond to (or, overlap) the second light emitting opening OP2-E or the conductive barrier wall PW. The second lower inorganic encapsulation pattern LIL2 may be disposed on the second auxiliary electrode SE2 and may cover the upper surface of the second auxiliary electrode SE2.

In an embodiment, the third lower inorganic encapsulation pattern LIL3 may be formed to correspond to (or, overlap) the third light emitting opening OP3-E or the conductive barrier wall PW. The third lower inorganic encapsulation pattern LIL3 may be disposed on the third auxiliary electrode SE3 and may cover the upper surface of the third auxiliary electrode SE3.

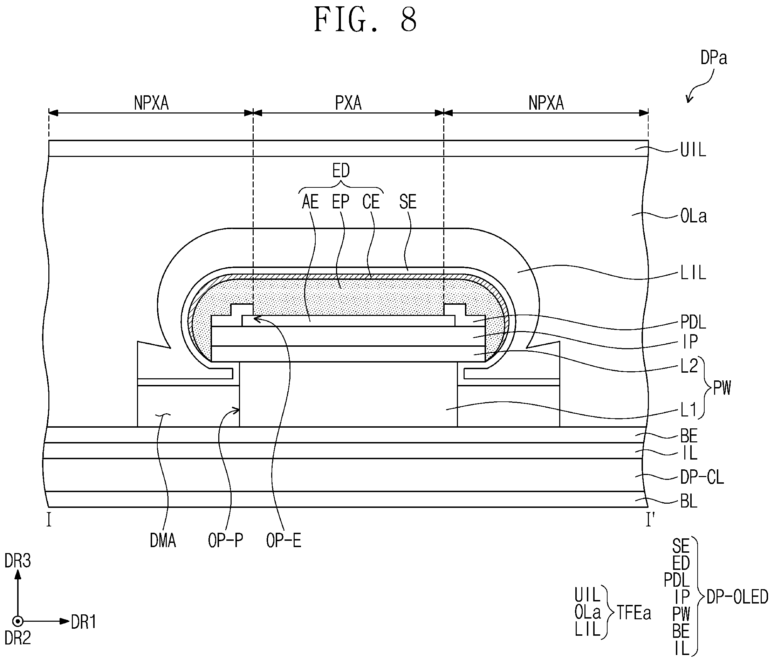

FIG. 8 is a cross-sectional view taken along line I-I' of FIG. 4, according to an embodiment. In describing FIG. 8, the description will be made with reference to FIG. 5, and descriptions of the same reference numerals will be omitted.

In an embodiment and referring to FIG. 8, a display panel DPa may include a base layer BL, a circuit element layer DP-CL, a display element layer DP-OLED, and a thin film encapsulation layer TFEa. The thin film encapsulation layer TFEa may include a lower inorganic encapsulation pattern LIL, an organic encapsulation film OLa, and an upper inorganic encapsulation film UIL.

In an embodiment, the lower inorganic encapsulation pattern LIL may be spaced part from a common electrode BE. The space by which the lower inorganic encapsulation pattern LIL and the common electrode BE are spaced apart from each other, as shown in the cross-section of FIG. 8, may be defined as a dummy region DMA.

In an embodiment, the organic encapsulation film OLa may be disposed on the lower inorganic encapsulation pattern LIL to cover the lower inorganic encapsulation pattern LIL and may provide a flat upper surface. The organic encapsulation film OLa may cover the upper surface and the side surface of the lower inorganic encapsulation pattern LIL. That is, the organic encapsulation film OLa may not fill the dummy region DMA. In this case, an additional inorganic film may be disposed between the lower inorganic encapsulation pattern LIL and the organic encapsulation film OLa. However, the shape or arrangement of the organic encapsulation film OLa is illustrative, and the invention is not limited thereto. For example, the organic encapsulation film OLa may fill the dummy region DMA, or may fill only a portion of the dummy region DMA.

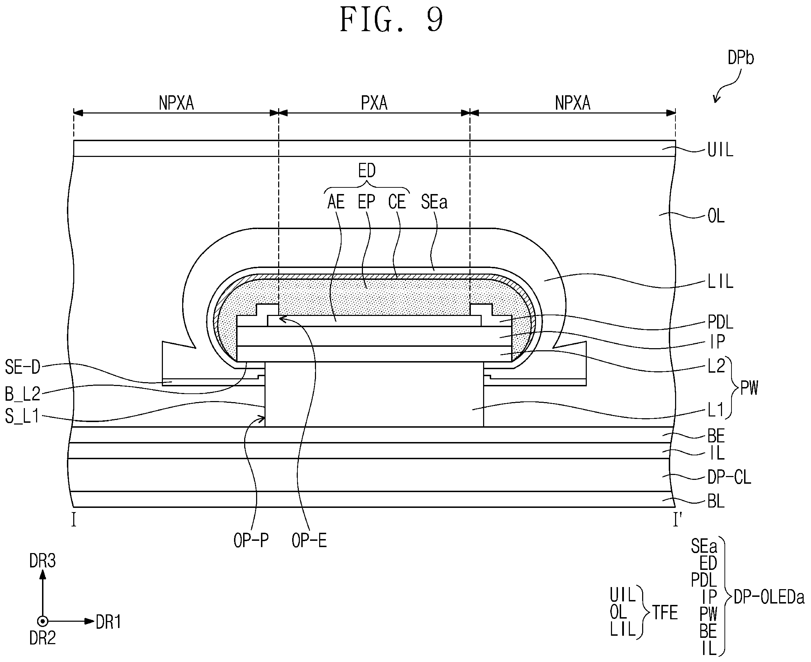

FIG. 9 is a cross-sectional view taken along line I-I' of FIG. 4, according to an embodiment. In describing FIG. 9, the description will be made with reference to FIG. 5, and descriptions of the same reference numerals will be omitted.

In an embodiment and referring to FIG. 9, a display panel DPb may include a base layer BL, a circuit element layer DP-CL, a display element layer DP-OLEDa, and a thin film encapsulation layer TFE. The display element layer DP-OLEDa may include an insulating layer IL, a common electrode BE, a conductive barrier wall PW, a barrier wall insulating layer IP, a pixel defining layer PDL, a light emitting element ED, an auxiliary electrode SEa, and a dummy auxiliary electrode SE-D. In another embodiment, in the display element layer DP-OLEDa, the pixel defining layer PDL may be omitted.

In an embodiment, the auxiliary electrode SEa may be disposed on a cathode CE. The auxiliary electrode SEa may cover the cathode CE and may cover the lower surface B_L2 of a second barrier wall layer L2 by making direct contact with the lower surface B_L2 of the second barrier wall layer L2.

In an embodiment, the dummy auxiliary electrode SE-D may make contact with the side surface S_L1 of a first barrier wall layer L1 and may protrude from the side surface S_L1 of the first barrier wall layer L1 toward the center of a barrier wall opening OP-P.

In an embodiment, the dummy auxiliary electrode SE-D may be spaced apart from the auxiliary electrode SEa. The dummy auxiliary electrode SE-D may be spaced apart from the auxiliary electrode SEa in the thickness direction of the display element layer DP-OLEDa (e.g., the third direction DR3). The dummy auxiliary electrode SE-D may include the same material as the auxiliary electrode SEa and may be formed through the same process as the auxiliary electrode SEa. For example, when the auxiliary electrode SE (refer to FIG. 5) is formed to be thick, the auxiliary electrode SE may extend from the lower surface B_L2 of the second barrier wall layer L2 to the side surface S_L1 of the first barrier wall layer L1, and when the auxiliary electrode SEa is formed to be relatively thin, the auxiliary electrode SEa may extend to the lower surface B_L2 of the second barrier wall layer L2, and the dummy auxiliary electrode SE-D which is spaced apart from the auxiliary electrode SEa may be additionally formed.

In an embodiment, the auxiliary electrode SEa may include a conductive material. The auxiliary electrode SEa may electrically connect the cathode CE and the conductive barrier wall PW by making contact with the cathode CE and the conductive barrier wall PW. The conductive barrier wall PW may receive a drive voltage (or, a bias voltage), and the cathode CE may receive the drive voltage (or, the bias voltage) accordingly.

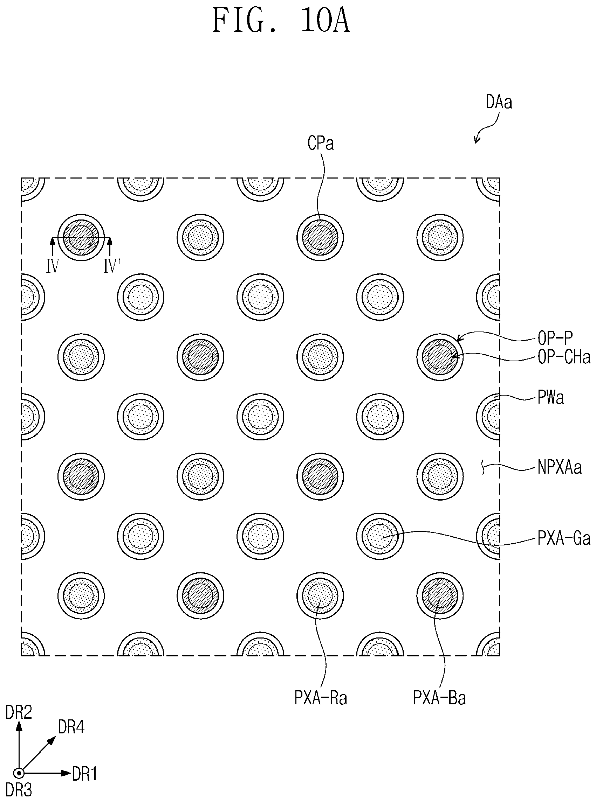

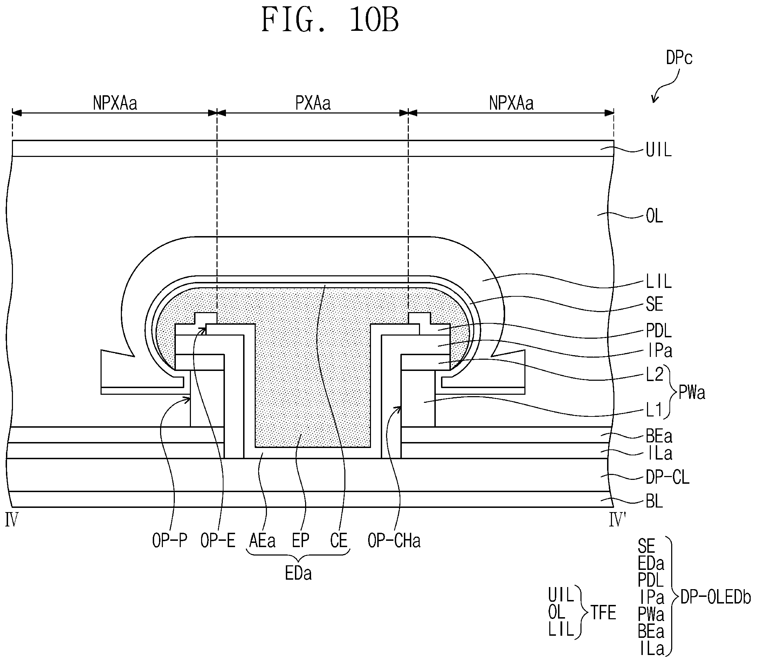

FIG. 10A is an enlarged plan view illustrating a portion of a display region DAa of a display panel DPc (refer to FIG. 10B), according to an embodiment. In an embodiment, FIG. 10A is a plan view of the display module DM as viewed from above the display surface IS (refer to FIG. 1B) of the display module DM (refer to FIG. 1B) and illustrates an arrangement of emissive regions PXA-Ra, PXA-Ga, and PXA-Ba and a conductive barrier wall PWa. FIG. 10B is a cross-sectional view taken along line IV-IV' of FIG. 10A, according to an embodiment. In describing FIGS. 10A and 10B, the description will be made with reference to FIGS. 4 and 5, and descriptions of the same reference numerals will be omitted.

In an embodiment and referring to FIG. 10A, the display region DAa may include the emissive regions PXA-Ra, PXA-Ga, and PXA-Ba and a peripheral region NPXAa surrounding the emissive regions PXA-Ra, PXA-Ga, and PXA-Ba. The emissive regions PXA-Ra, PXA-Ga, and PXA-Ba of FIG. 10A may be substantially the same as the emissive regions PXA-R, PXA-G, and PXA-B of FIG. 4 in terms of placement, arrangement, area, and function, except for shape.

In an embodiment, each of the emissive regions PXA-Ra, PXA-Ga, and PXA-Ba of FIG. 10A may include a circular part CPa. That is, unlike the emissive regions PXA-R, PXA-G, and PXA-B of FIG. 4, in an embodiment, the emissive regions PXA-Ra, PXA-Ga, and PXA-Ba of FIG. 10A may not include the protruding part PP (refer to FIG. 4).

In an embodiment and referring to FIGS. 10A and 10B, the circular parts CPa of the emissive regions PXA-Ra, PXA-Ga, and PXA-Ba may be regions through which light provided from light emitting elements is emitted. A light emitting contact hole OP-CHa may overlap the center of the circular part CPa when viewed from above the plane. The light emitting contact hole OP-CHa may be defined to penetrate a conductive barrier wall PWa, a common electrode BEa, and an insulating layer ILa, and a first electrode AEa may be electrically connected with a corresponding transistor TR1 (refer to FIG. 5) through the light emitting contact hole OP-CHa. The light emitting contact hole OP-CHa may overlap the first electrode AEa when viewed from above the plane. A barrier wall opening OP-P of the conductive barrier wall PWa and the anode AEa may be spaced apart from each other when viewed from above the plane. That is, the barrier wall opening OP-P and the anode AEa may be formed so as not to overlap each other when viewed from above the plane.

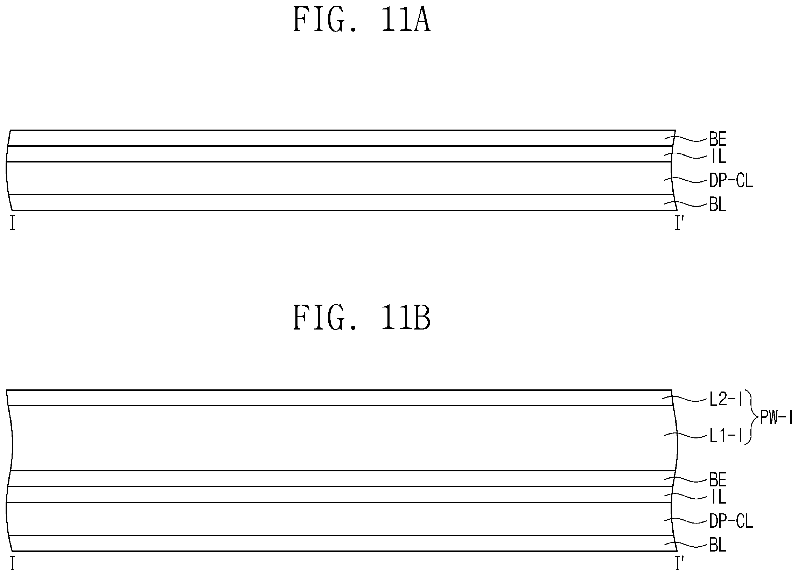

FIGS. 11A to 11L are cross-sectional views illustrating some of the steps of a display panel manufacturing method, according to an embodiment. In describing FIGS. 11A to 11L, components identical/similar to the components described above with reference to FIGS. 1 to 7 will be assigned with identical/similar reference numerals, and repetitive descriptions will be omitted.

In an embodiment, the display panel manufacturing method includes a step of forming a common electrode and a circuit element layer including a transistor on a base layer, a step of forming a preliminary conductive barrier wall on the common electrode, a step of forming a preliminary barrier wall insulating layer, a first electrode, and a preliminary pixel defining layer covering the first electrode on the preliminary conductive barrier wall, a step of forming a light emitting opening overlapping the first electrode by etching the preliminary pixel defining layer, a step of forming a conductive barrier wall having a barrier wall opening defined therein, a barrier wall insulating layer, and a pixel defining layer by etching the preliminary conductive barrier wall, the preliminary barrier wall insulating layer, and the preliminary pixel defining layer, a step of forming an emission pattern covering the first electrode on the conductive barrier wall, and a step of forming a second electrode electrically connected with the conductive barrier wall on the emission pattern, where the light emitting opening and the barrier wall opening may not overlap each other when viewed from above a plane.

Hereinafter, an embodiment of a method of forming one light emitting element (e.g., the first light emitting element ED1 (refer to FIG. 7)) and a lower inorganic encapsulation pattern (e.g., the first lower inorganic encapsulation pattern LIL1 (refer to FIG. 7)), an organic encapsulation film OL, and an upper inorganic encapsulation film UIL that cover the light emitting element (e.g., the first light emitting element ED1) will be described with reference to FIGS. 11A to 11L. A display panel formed through the method illustrated in FIGS. 11A to 11L, according to an embodiment, may correspond to the display panel DP of FIG. 5.

In an embodiment and referring to FIG. 11A, a display panel manufacturing method may include the step of forming the common electrode BE and the circuit element layer DP-CL including the transistor TR1 (refer to FIG. 6) on the base layer BL.

In an embodiment, the circuit element layer DP-CL including the transistor TR1 may be formed through a conventional circuit element manufacturing process of forming an insulating layer, a semiconductor layer, and a conductive layer by coating, deposition, or the like and forming a semiconductor pattern, a conductive pattern, and a signal line by selectively making the insulating layer, the semiconductor layer, and the conductive layer subject to patterning by photolithography and etching processes. In an embodiment, the display panel manufacturing method of the invention may further include a step of depositing an insulating layer IL on the circuit element layer DP-CL.

In an embodiment, the common electrode BE may be disposed on the base layer BL. In detail, the common electrode BE may be formed on the insulating layer IL. The common electrode BE may be commonly disposed in the entire display region DA (refer to FIG. 4) and may be formed to provide a common voltage.

In an embodiment and referring to FIG. 11B, the display panel manufacturing method may include the step of forming the preliminary conductive barrier wall PW-I on the common electrode BE. The preliminary conductive barrier wall PW-I may include a first preliminary barrier wall layer L1-I disposed on the common electrode BE and a second preliminary barrier wall layer L2-I disposed on the first preliminary barrier wall layer L1-I.

In an embodiment, the step of forming the first and second preliminary barrier wall layers L1-I and L2-I may be performed by a process of depositing a conductive material. For example, in an embodiment, the conductive material may include metal, transparent conductive oxide (TCO), or a combination thereof. For example, in an embodiment, the metal may include gold (Au), silver (Ag), aluminium (Al), magnesium (Mg), lithium (Li), molybdenum (Mo), titanium (Ti), copper (Cu), or an alloy. The transparent conductive oxide may include indium tin oxide (ITO), indium zinc oxide (IZO), zinc oxide, indium oxide, indium gallium oxide, indium gallium zinc oxide (IGZO), or aluminium zinc oxide. In an embodiment, the second preliminary barrier wall layer L2-I may include the same material as the common electrode BE, and the first preliminary barrier wall layer L1-I and the second preliminary barrier wall layer L2-I may include different materials. However, this is illustrative, and the invention is not limited thereto.

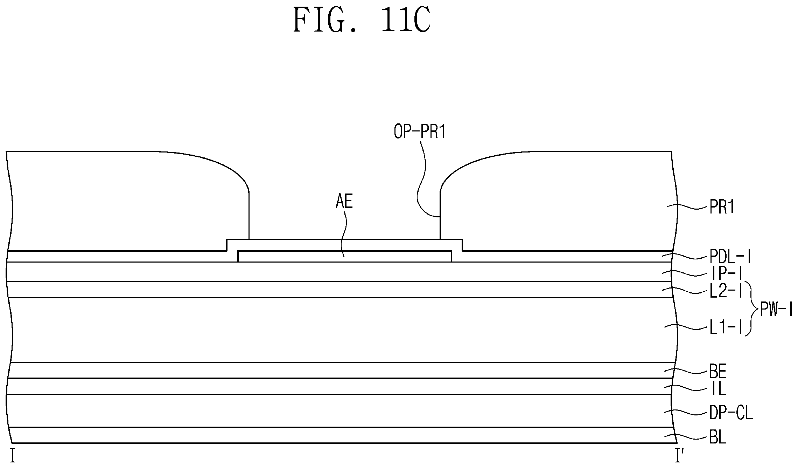

In an embodiment and referring to FIG. 11C, the display panel manufacturing method may include the step of forming the preliminary barrier wall insulating layer IP-I, the first electrode AE (or, the anode), and the preliminary pixel defining layer PDL-I covering the first electrode AE on the preliminary conductive barrier wall PW-I.

In an embodiment, the preliminary barrier wall insulating layer IP-I may be formed on the preliminary conductive barrier wall PW-I, and the anode AE may be formed on the preliminary barrier wall insulating layer IP-I. The preliminary pixel defining layer PDL-I may be formed to cover the anode AE.

In an embodiment, the display panel manufacturing method may further include a step of forming a first photoresist layer PR1 on the preliminary pixel defining layer PDL-I. The first photoresist layer PR1 may be formed by forming a preliminary photoresist layer on the preliminary pixel defining layer PDL-I and thereafter making the preliminary photoresist layer subject to patterning using a photo mask. Through the patterning process, a first photo opening OP-PR1 overlapping the anode AE may be formed in the first photoresist layer PR1.

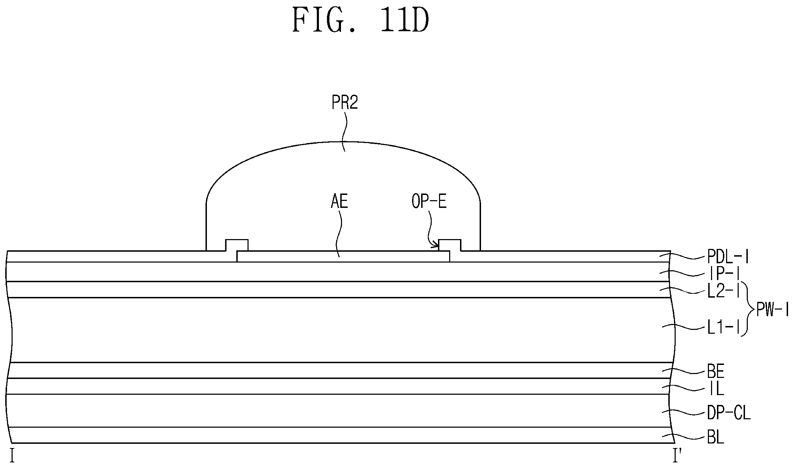

In an embodiment and referring to FIG. 11D, the display panel manufacturing method may include the step of forming the light emitting opening OP-E overlapping the anode AE (or, the first electrode) by etching the preliminary pixel defining layer PDL-I.

In an embodiment, the step of etching the preliminary pixel defining layer PDL-I may be performed by dry etching a portion of the preliminary pixel defining layer PDL-I using the first photoresist layer PR1 (refer to FIG. 11C) as a mask. The etched portion of the preliminary pixel defining layer PDL-I may be removed, and the light emitting opening OP-E may be formed in the preliminary pixel defining layer PDL-I accordingly. The light emitting opening OP-E may overlap the anode AE (or, the first electrode).

In an embodiment, the display panel manufacturing method may further include a step of forming a second photoresist layer PR2 on the preliminary pixel defining layer PDL-I after removing the first photoresist layer PR1. The second photoresist layer PR2 may be formed by forming a preliminary photoresist layer on the preliminary pixel defining layer PDL-I and thereafter making the preliminary photoresist layer subject to patterning using a photo mask. Through the patterning process, the second photoresist layer PR2 may overlap the light emitting opening OP-E.

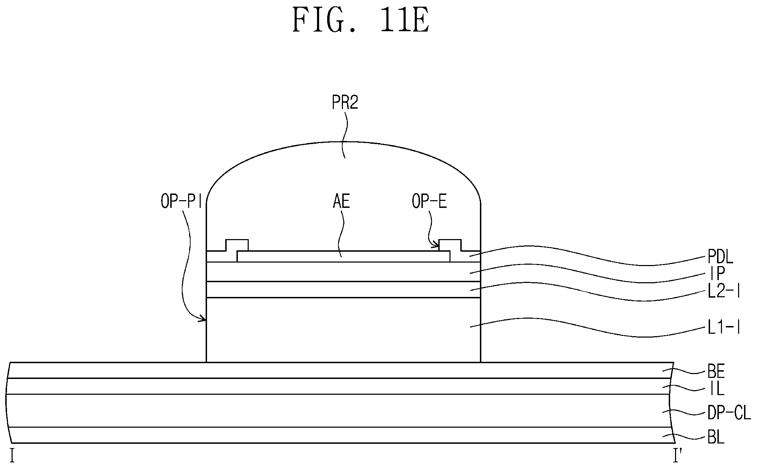

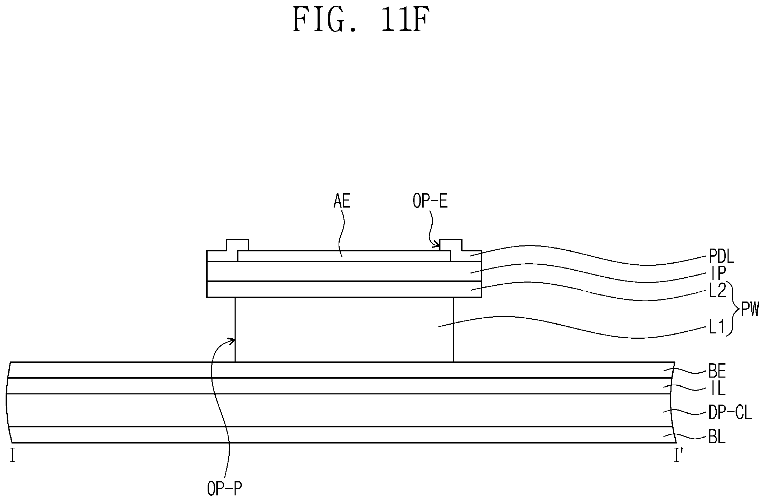

In an embodiment and referring to FIGS. 11E and 11F, the display panel manufacturing method may include the step of forming the conductive barrier wall PW having the barrier wall opening OP-P defined therein, the barrier wall insulating layer IP, and the pixel defining layer PDL by etching the preliminary conductive barrier wall PW-I (refer to FIG. 11D), the preliminary barrier wall insulating layer IP-I (refer to FIG. 11D), and the preliminary pixel defining layer PDL-I (refer to FIG. 11D).

In an embodiment, the step of forming the conductive barrier wall PW having the barrier wall opening OP-P defined therein, the barrier wall insulating layer IP, and the pixel defining layer PDL by etching the preliminary conductive barrier wall PW-I (refer to FIG. 11D), the preliminary barrier wall insulating layer IP-I (refer to FIG. 11D), and the preliminary pixel defining layer PDL-I (refer to FIG. 11D) may include a step of firstly etching the preliminary conductive barrier wall PW-I, the preliminary barrier wall insulating layer IP-I, and the preliminary pixel defining layer PDL-I and a step of forming a first barrier wall layer L1 and a second barrier wall layer L2 by secondly etching the first preliminary barrier wall layer L1-I of the preliminary conductive barrier wall PW-I. The first etching step will be described with reference to FIG. 11E, and the second etching step will be described with reference to FIG. 11F.

In an embodiment and as illustrated in FIG. 11E, the preliminary conductive barrier wall PW-I (refer to FIG. 11D), the preliminary barrier wall insulating layer IP-I (refer to FIG. 11D), and the preliminary pixel defining layer PDL-I (refer to FIG. 11D) may be dry etched using the second photoresist layer PR2 as a mask. The etched portions of the preliminary conductive barrier wall PW-I, the preliminary barrier wall insulating layer IP-I, and the preliminary pixel defining layer PDL-I may be removed, and a preliminary barrier wall opening OP-PI may be formed in the preliminary conductive barrier wall PW-I.

In an embodiment and as illustrated in FIG. 11F, the first preliminary barrier wall layer L1-I of the preliminary conductive barrier wall PW-I may be wet etched using the second photoresist layer PR2 as a mask. The etched portion of the first preliminary barrier wall layer L1-I may be removed, and the first barrier wall layer L1 and the second barrier wall layer L2 may be formed. The first barrier wall layer L1 and the second barrier wall layer L2 may be referred to as the conductive barrier wall PW. The barrier wall opening OP-P may be formed in the conductive barrier wall PW. The barrier wall opening OP-P may include the first region A1 (refer to FIG. 5) and the second region A2 (refer to FIG. 5). The light emitting opening OP-E and the barrier wall opening OP-P may not overlap each other when viewed from above the plane.

In an embodiment, the wet etching process may be performed in an environment in which the etch selectivity between the first barrier wall layer L1 and the second barrier wall layer L2 is high. Accordingly, the inner surface of the conductive barrier wall PW that defines the barrier wall opening OP-P may have an undercut shape. Specifically, since the etch rate of the first barrier wall layer L1 by an etchant is higher than the etch rate of the second barrier wall layer L2 by the etchant, the first barrier wall layer L1 may be mainly etched. Accordingly, the inner surface of the first barrier wall layer L1 may be further recessed inward when compared to the inner surface of the second barrier wall layer L2. A tip portion may be formed in the conductive barrier wall PW by the portion of the second barrier wall layer L2 that further protrudes when compared to the first barrier wall layer L1.

Although FIGS. 11E and 11F illustrate an embodiment that the one barrier wall opening OP-P is formed, the invention is not limited thereto. In an embodiment, the step of forming the barrier wall opening OP-P may include a step of simultaneously forming the barrier wall openings OP-P (refer to FIG. 7) that correspond to the emissive regions PXA-R, PXA-G, and PXA-B (refer to FIG. 7). In an embodiment, the step of forming the barrier wall opening OP-P may include a step of forming only the barrier wall opening OP-P corresponding to the first emissive region PXA-R. For example, after the barrier wall opening OP-P corresponding to the first emissive region PXA-R is formed and then the first light emitting element ED1 (refer to FIG. 7) is formed through a subsequent process, the barrier wall opening OP-P corresponding to the second emissive region PXA-G may be formed. In addition, through a subsequent process, the second light emitting element ED2 (refer to FIG. 7) may be formed, and the barrier wall opening OP-P corresponding to the third emissive region PXA-B may be formed.

In an embodiment and referring to FIG. 11G, the display panel manufacturing method may include the step of forming the emission pattern EP covering the first electrode AE (or, the anode) on the conductive barrier wall PW after removing the second photoresist layer PR2 (refer to FIG. 11F).

In an embodiment, the step of forming the emission pattern EP may include a deposition process of an emissive layer. In an embodiment, the deposition process of the emissive layer may be a thermal evaporation process. However, this is illustrative, and the deposition process of the emissive layer is not limited to the above example. In an embodiment, the emissive layer may be divided by the tip portion formed in the conductive barrier wall PW and may form the emission pattern EP and the first dummy layer D1. The emission pattern EP may be formed to cover the side surface of the barrier wall insulating layer IP and the side surface of the second barrier wall layer L2, and the first dummy layer D1 may be formed on the common electrode BE.

In an embodiment, in the step of forming the emission pattern EP, the first dummy layer D1 which is spaced apart from the emission pattern EP may be formed together. The first dummy layer D1 may include an organic material. For example, the first dummy layer D1 may include the same material as the emission pattern EP. The first dummy layer D1 may be simultaneously formed with the emission pattern EP through one process and may be separated from the emission pattern EP by the undercut shape of the conductive barrier wall PW.

In an embodiment and referring to FIG. 11H, the display panel manufacturing method may include the step of forming the second electrode CE (or, the cathode) electrically connected with the conductive barrier wall PW on the emission pattern EP.

In an embodiment, the step of forming the cathode CE may include a deposition process of a cathode layer. In an embodiment, the deposition process of the cathode layer may be a thermal evaporation process. However, this is illustrative, and the deposition process of the cathode layer is not limited to the above example. In an embodiment, the cathode layer may be divided by the tip portion formed in the conductive barrier wall PW and may form the cathode CE and the second dummy layer D2. The cathode CE may be formed to cover the upper surface of the emission pattern EP and at least a portion of the side surface of the emission pattern EP, and the second dummy layer D2 may be formed on the first dummy layer D1.

In an embodiment, in the step of forming the cathode CE, the second dummy layer D2 which is spaced apart from the cathode CE may be formed together. The second dummy layer D2 may include a conductive material. For example, the second dummy layer D2 may include the same material as the cathode CE. The second dummy layer D2 may be simultaneously formed with the cathode CE through one process and may be separated from the cathode CE by the undercut shape of the conductive barrier wall PW.

In an embodiment, the anode AE, the emission pattern EP, and the cathode CE may be sequentially stacked in the third direction DR3. The anode AE, the emission pattern EP, and the cathode CE may form a light emitting element ED. The first dummy layer D1 and the second dummy layer D2 may be sequentially stacked in the third direction DR3.

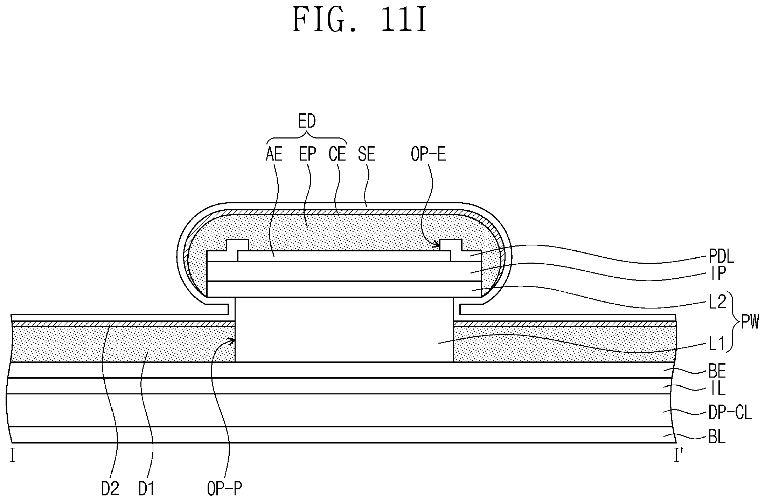

In an embodiment and referring to FIG. 11I, the display panel manufacturing method may include a step of forming an auxiliary electrode SE that covers the second electrode CE (or, the cathode) and the lower surface of the second barrier wall layer L2.

In an embodiment, the step of forming the auxiliary electrode SE may include a deposition process of an auxiliary electrode layer. The deposition process of the auxiliary electrode layer may be a sputtering process. However, this is illustrative, and the deposition process of the auxiliary electrode layer is not limited to the above example.

In an embodiment, the auxiliary electrode layer may include a conductive material. For example, the conductive material may include metal, transparent conductive oxide (TCO), or a combination thereof. For example, the metal may include gold (Au), silver (Ag), aluminium (Al), magnesium (Mg), lithium (Li), molybdenum (Mo), titanium (Ti), copper (Cu), or an alloy. The transparent conductive oxide may include indium tin oxide (ITO), indium zinc oxide (IZO), zinc oxide, indium oxide, indium gallium oxide, indium gallium zinc oxide (IGZO), or aluminium zinc oxide.

In an embodiment, the auxiliary electrode SE may be disposed on the cathode CE. The auxiliary electrode SE may cover the cathode CE and may cover the lower surface B_L2 of the second barrier wall layer L2 by making direct contact with the lower surface B_L2 (refer to FIG. 5) of the second barrier wall layer L2. In an embodiment, the auxiliary electrode SE may extend along the lower surface B_L2 (refer to FIG. 5) of the second barrier wall layer L2 and the side surface S_L1 (refer to FIG. 5) of the first barrier wall layer L1. That is, the auxiliary electrode SE may be formed to make contact with the side surface S_L1 of the first barrier wall layer L1. However, this is illustrative, and the shape of the auxiliary electrode SE is not limited to the above example. In an embodiment, the auxiliary electrode SE may extend to the lower surface B_L2 of the second barrier wall layer L2, and a dummy auxiliary electrode SE-D (See FIG. 9) may be formed to make contact with the side surface S_L1 of a first barrier wall layer L1 and protrude from the side surface S_L1 of the first barrier wall layer L1 toward the center of the barrier wall opening OP-P.

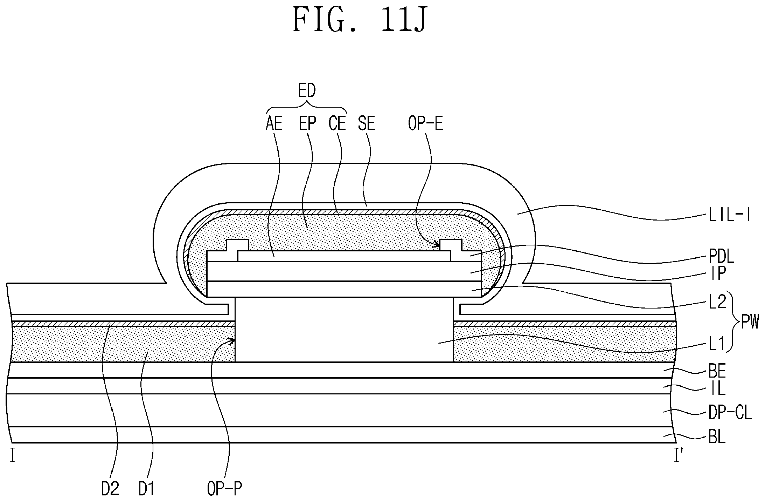

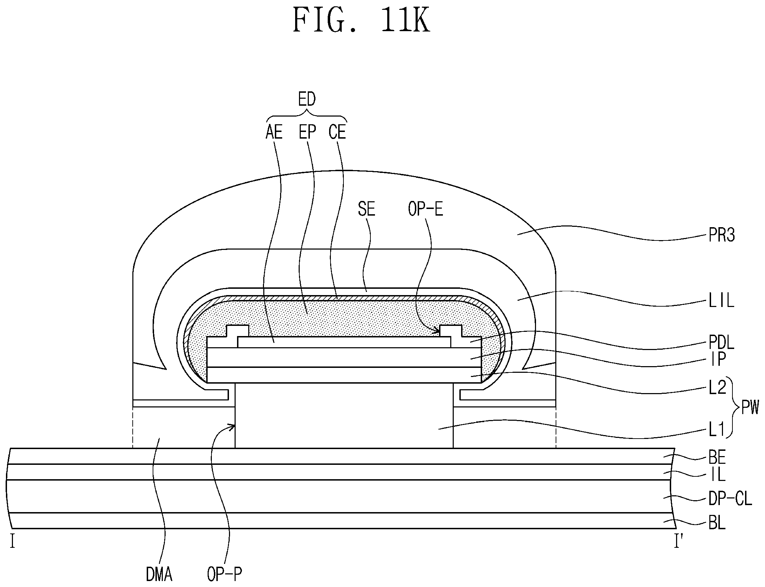

In an embodiment and referring to FIGS. 11J and 11K, the display panel manufacturing method may include the step of forming the lower inorganic encapsulation pattern LIL that covers the auxiliary electrode SE. The step of forming the lower inorganic encapsulation pattern LIL may include a step of depositing a lower inorganic encapsulation layer LIL-I and a step of removing a portion of the lower inorganic encapsulation layer LIL-I that does not overlap the light emitting element ED.

In an embodiment and referring to FIG. 11J, the step of forming the lower inorganic encapsulation pattern LIL may include a step of depositing the lower inorganic encapsulation layer LIL-I. The lower inorganic encapsulation layer LIL-I may be formed through a deposition process. In an embodiment, the lower inorganic encapsulation layer LIL-I may be formed through a chemical vapor deposition (CVD) process. The lower inorganic encapsulation layer LIL-I may be formed to cover the upper surface of the auxiliary electrode SE.

In an embodiment and referring to FIG. 11K, the step of forming the lower inorganic encapsulation pattern LIL may include a step of forming a third photoresist layer PR3 and a step of removing a portion of the lower inorganic encapsulation layer LIL-I (refer to FIG. 11J) that does not overlap the light emitting element ED.

In an embodiment, in the step of forming the third photoresist layer PR3, the third photoresist layer PR3 may be formed by forming a preliminary photoresist layer and making the preliminary photoresist layer subject to patterning using a photo mask. Through the patterning process, the third photoresist layer PR3 may be formed in the form of a pattern corresponding to the light emitting element ED.

In an embodiment, in the step of removing the portion of the lower inorganic encapsulation layer LIL-I that does not overlap the light emitting element ED, the lower inorganic encapsulation layer LIL-I may be subjected to patterning such that the portion of the lower inorganic encapsulation layer LIL-I that does not overlap the light emitting element ED is removed by dry etching the lower inorganic encapsulation layer LIL-I using the third photoresist layer PR3 as a mask. The lower inorganic encapsulation pattern LIL overlapping the light emitting element ED may be formed from the patterned lower inorganic encapsulation layer LIL-I.

In an embodiment, the display panel manufacturing method may further include a step of forming a dummy region DMA by removing the dummy layers D1 and D2 (refer to FIG. 11J). The second dummy layer D2 may be removed by wet etching, and the first dummy layer D1 may be removed by a stripper. In an embodiment, the dummy region DMA may be formed between the conductive barrier wall PW and the lower inorganic encapsulation pattern LIL by the removal of the dummy layers D1 and D2. As the dummy region DMA is formed, the lower inorganic encapsulation pattern LIL may be spaced apart from the common electrode BE by the dummy region DMA.

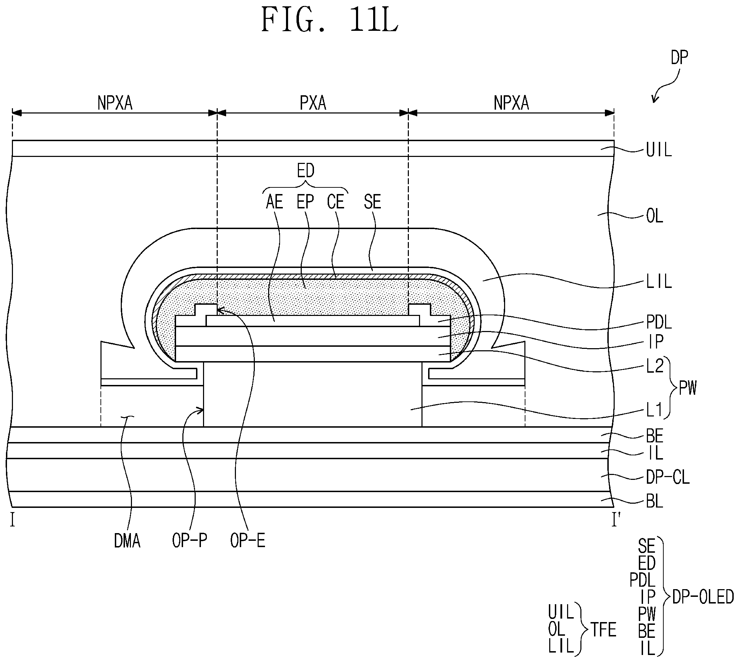

In an embodiment and referring to FIG. 11L, the display panel manufacturing method may include a step of completing the display panel DP by forming the organic encapsulation film OL and the upper inorganic encapsulation film UIL after removing the third photoresist layer PR3 (refer to FIG. 11K). The organic encapsulation film OL may be formed by applying an organic material using an inkjet method, but is not limited thereto. The organic encapsulation film OL provides a flat upper surface. The organic encapsulation film OL may fill the dummy region DMA. However, this is illustrative, and the invention is not limited thereto. For example, the organic encapsulation film OL may not fill the dummy region DMA and may fill only a portion of the dummy region DMA.

In an embodiment, the upper inorganic encapsulation film UIL may be formed by depositing an inorganic material. Accordingly, the display panel DP including the base layer BL, the circuit element layer DP-CL, the display element layer DP-OLED, and the thin film encapsulation layer TFE may be formed.

In an embodiment, a step of forming barrier wall openings and light emitting openings corresponding to emissive regions having other colors in the conductive barrier wall PW and the pixel defining layer PDL, a step of forming light emitting elements that provide the other colors, and a step of forming auxiliary electrodes covering the light emitting elements providing the other colors and lower inorganic encapsulation patterns covering the auxiliary electrodes may be additionally performed between the step of forming the lower inorganic encapsulation pattern LIL and the step of completing the display panel DP. Accordingly, the display panel DP including the light emitting elements ED1, ED2, and ED3, the auxiliary electrodes SE1, SE2, and SE3, and the lower inorganic encapsulation patterns LIL1, LIL2, and LIL3 illustrated in FIG. 7 may be formed.

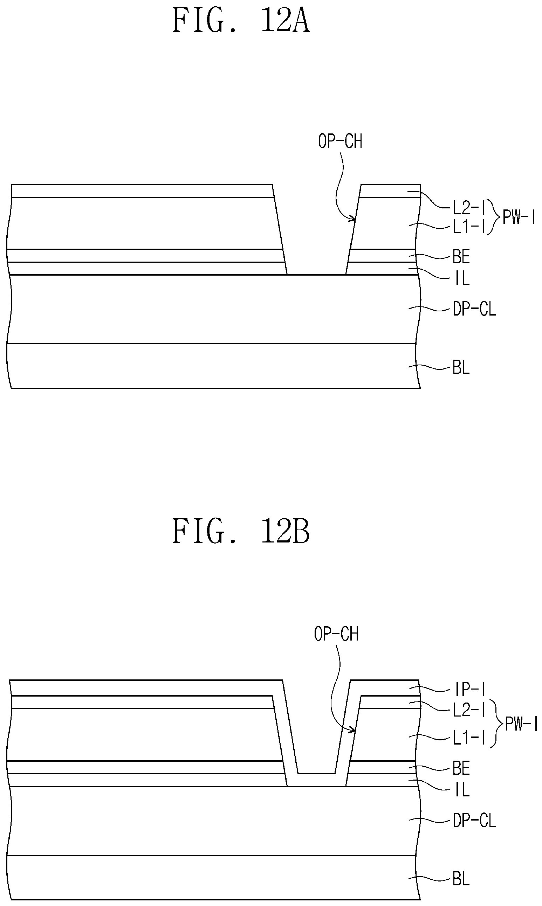

FIGS. 12A to 12D are cross-sectional views illustrating some of the steps of the display panel manufacturing method, according to an embodiment. In describing FIGS. 12A to 12D, components identical/similar to the components described with reference to FIGS. 1 to 11L will be assigned with identical/similar reference numerals, and repetitive descriptions will be omitted.

In an embodiment, a process in which the first electrode AE (or, the anode) of the display region DA is electrically connected with the transistor TR1 will be described with reference to FIGS. 12A to 12D. The process that will be described with reference to FIGS. 12A to 12D may correspond to a process between FIG. 11B and FIG. 11C. A portion of the display panel formed through the method illustrated in FIGS. 12A to 12D may correspond to a portion of the display panel of FIG. 6.

In an embodiment and referring to FIG. 12A, the display panel manufacturing method may include a step of forming a light emitting contact hole OP-CH by etching the preliminary conductive barrier wall PW-I, the insulating layer IL and the common electrode BE. The step of forming the light emitting contact hole OP-CH may be performed using a photoresist layer.

In an embodiment, the preliminary conductive barrier wall PW-I, the common electrode BE, and the insulating layer IL may be etched using the photoresist layer as a mask. The etched portions of the preliminary conductive barrier wall PW-I, the common electrode BE, and the insulating layer IL may be removed, and the light emitting contact hole OP-CH may be formed in the preliminary conductive barrier wall PW-I, the common electrode BE, and the insulating layer IL.

In an embodiment and referring to FIG. 12B, in the display panel manufacturing method, the step of forming the preliminary barrier wall insulating layer IP-I, the first electrode AE (refer to FIG. 11C), and the preliminary pixel defining layer PDL-I (refer to FIG. 11C) on the preliminary conductive barrier wall PW-I may include a step of forming the preliminary barrier wall insulating layer IP-I that covers the inner surface of the light emitting contact hole OP-CH.

In an embodiment, the preliminary barrier wall insulating layer IP-I may be formed to cover the upper surface of the second preliminary barrier wall layer L2-I, the side surface of the second preliminary barrier wall layer L2-I, the side surface of the first preliminary barrier wall layer L1-I, the side surface of the common electrode BE, the side surface of the insulating layer IL, and the upper surface of the circuit element layer DP-CL. The side surface of the second preliminary barrier wall layer L2-I, the side surface of the first preliminary barrier wall layer L1-I, the side surface of the common electrode BE, and the side surface of the insulating layer IL may define the inner surface of the light emitting contact hole OP-CH. That is, the preliminary barrier wall insulating layer IP-I may be formed to cover the inner surface of the light emitting contact hole OP-CH.

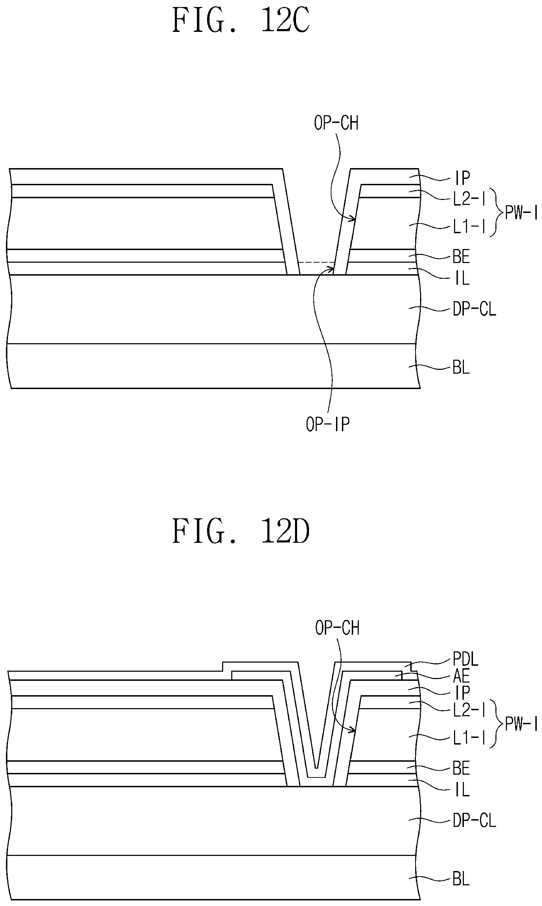

In an embodiment and referring to FIG. 12C, the display panel manufacturing method may include a step of forming a barrier wall insulating layer opening OP-IP by etching a portion of the preliminary barrier wall insulating layer IP-I (refer to FIG. 12B). A portion of the preliminary barrier wall insulating layer IP-I that covers the upper surface of the circuit element layer DP-CL may be etched and removed. The barrier wall insulating layer opening OP-IP may be formed in the etched and a portion may be removed, and the barrier wall insulating layer IP may be formed from the preliminary barrier wall insulating layer IP-I. A portion of the upper surface of the circuit element layer DP-CL may be exposed by the barrier wall insulating layer opening OP-IP.

In an embodiment and referring to FIGS. 6 and 12D, the display panel manufacturing method may include a step of forming the anode AE and the pixel defining layer PDL on the barrier wall insulating layer IP.

In an embodiment, the anode AE may be formed to overlap the light emitting contact hole OP-CH. The anode AE may be formed in the light emitting contact hole OP-CH. The anode AE may make contact with the circuit element layer DP-CL through the light emitting contact hole OP-CH. In an embodiment, the anode AE may make contact with the upper surface of the contact hole CNT-3 that is not covered by the barrier wall insulating layer IP and may be connected to the second connecting electrode CNE2. Accordingly, the anode AE may be electrically connected to the signal transmission region SCL through the first and second connecting electrodes CNE1 and CNE2 and may be electrically connected to a corresponding circuit element (e.g., the transistor TR1).

In an embodiment, since the light emitting element is formed on the conductive barrier wall rather than in the barrier wall opening of the conductive barrier wall as described above, an occurrence of a shadow region may be prevented in a deposition process. Accordingly, the invention may provide the display panel that facilitates implementing high resolution.

In an embodiment, since the lower inorganic encapsulation pattern covering the light emitting element formed on the conductive barrier wall is more stable and robust and the light emitting element is not disposed in the barrier wall opening, the thickness of the conductive barrier wall may be decreased.

While the invention has been described with reference to embodiments thereof, it will be apparent to those of ordinary skill in the art that various changes and modifications may be made thereto without departing from the scope of the invention. Therefore, the invention should not be limited to any single embodiment described herein or otherwise. Moreover, embodiments or parts of the embodiments may be combined in whole or in part without departing from the scope of the invention.

## Claims

1. A display panel comprising: a base layer (BL); a transistor (TR1) disposed on the base layer; a common electrode (BE) disposed on the transistor; a conductive barrier wall (PW) disposed on the common electrode, the conductive barrier wall having a barrier wall opening (OP-P); a barrier wall insulating layer (IP) disposed on the conductive barrier wall; and a light emitting element (ED) disposed on the barrier wall insulating layer, the light emitting element including a first electrode (AE) electrically connected to the transistor, an emission pattern (EP) disposed on the first electrode, and a second electrode (CE) disposed on the emission pattern and electrically connected with the conductive barrier wall.

2. The display panel of claim 1, wherein the conductive barrier wall includes:
a first barrier wall layer disposed on the common electrode; and
a second barrier wall layer disposed on the first barrier wall layer,
wherein the barrier wall opening includes:
a first region defined by the first barrier wall layer; and
a second region defined by the second barrier wall layer and integrally formed with the first region, and
wherein the first region has a greater length in a first direction than the second region.

3. The display panel of claim 2, further comprising:
a pixel defining layer disposed on the barrier wall insulating layer, the pixel defining layer having a light emitting opening configured to expose at least a portion of the first electrode.

4. The display panel of claim 3, wherein the light emitting opening does not overlap the barrier wall opening.

5. The display panel of any one of claims 2 to 4, wherein the emission pattern covers a side surface of the second barrier wall layer, and the second electrode covers an upper surface of the emission pattern and at least a portion of a side surface of the emission pattern.

6. The display panel of any one of claims 2 to 5, further comprising:
an auxiliary electrode configured to cover the second electrode and a lower surface of the second barrier wall layer and make direct contact with the lower surface of the second barrier wall layer.

7. The display panel of claim 6, wherein:
(i) the auxiliary electrode makes contact with a side surface of the first barrier wall layer; or
(ii) the display panel further comprises:
a dummy auxiliary electrode spaced apart from the auxiliary electrode and configured to make contact with a side surface of the first barrier wall layer.

8. The display panel of claim 6 or claim 7, further comprising:
a lower inorganic encapsulation pattern configured to cover an upper surface of the auxiliary electrode, wherein the lower inorganic encapsulation pattern is spaced apart from the common electrode.

9. The display panel of any one of claims 1 to 8, further comprising:
a light emitting contact hole configured to penetrate the conductive barrier wall and the common electrode and overlap the first electrode when viewed from above a plane, optionally wherein:
(i) the first electrode includes a circular part and a protruding part configured to extend from one side of the circular part, wherein the light emitting contact hole overlaps the protruding part when viewed from above the plane; or
(ii) the first electrode includes a circular part, wherein the light emitting contact hole overlaps a center of the circular part when viewed from above the plane.

10. The display panel of any one of claims 1 to 9, wherein the first electrode is disposed between the second electrode and the common electrode.

11. A method for manufacturing a display panel, the method comprising: forming a circuit element layer (DP-CL) and a common electrode (BE) on a base layer (BL), the circuit element layer including a transistor (TR1); forming a preliminary conductive barrier wall (PW-I) on the common electrode; forming, on the preliminary conductive barrier wall, a preliminary barrier wall insulating layer (IP-I), a first electrode (AE), and a preliminary pixel defining layer (PDL-I ) configured to cover the first electrode; forming a light emitting opening (OP-E) configured to overlap the first electrode, by etching the preliminary pixel defining layer; forming a conductive barrier wall (PW), a barrier wall insulating layer (IP), and a pixel defining layer (PDL) by etching the preliminary conductive barrier wall, the preliminary barrier wall insulating layer, and the preliminary pixel defining layer, wherein a barrier wall opening (OP-P) is defined in the conductive barrier wall; forming, on the conductive barrier wall, an emission pattern (EP) configured to cover the first electrode; and forming, on the emission pattern, a second electrode (CE) electrically connected with the conductive barrier wall, wherein the light emitting opening and the barrier wall opening do not overlap each other when viewed from above a plane.

12. The method of claim 11, wherein the preliminary conductive barrier wall includes:
a first preliminary barrier wall layer disposed on the common electrode; and
a second preliminary barrier wall layer disposed on the first preliminary barrier wall layer, and
wherein the forming of the conductive barrier wall, the barrier wall insulating layer, and the pixel defining layer includes:
firstly etching the preliminary conductive barrier wall, the preliminary barrier wall insulating layer, and the preliminary pixel defining layer; and
forming a first barrier wall layer and a second barrier wall layer by secondly etching the first preliminary barrier wall layer.

13. The method of claim 12, further comprising:
forming an auxiliary electrode configured to cover the second electrode and a lower surface of the second barrier wall layer.

14. The method of claim 13, wherein:
(i) the auxiliary electrode is in contact with a side surface of the first barrier wall layer; and/or
(ii) the method further comprises:
forming a lower inorganic encapsulation pattern configured to cover an upper surface of the auxiliary electrode,
wherein the lower inorganic encapsulation patterns are spaced apart from the common electrode.

15. The method of any one of claims 11 to 14, further comprising:
forming a light emitting contact hole by etching the preliminary conductive barrier wall and the common electrode,
wherein the first electrode and the transistor are electrically connected with each other through the light emitting contact hole, optionally wherein the forming of the preliminary barrier wall insulating layer, the first electrode, and the preliminary pixel defining layer configured to cover the first electrode on the preliminary conductive barrier wall includes:
forming the preliminary barrier wall insulating layer configured to cover an inner surface of the light emitting contact hole.

## Patentansprüche

1. Anzeigefeld, umfassend:
eine Basisschicht (BL); ein auf der Basisschicht angeordneter Transistor (TR1); eine auf dem Transistor angeordnete gemeinsame Elektrode (BE); eine auf der gemeinsamen Elektrode angeordnete leitfähige Barrierewand (PW), wobei die leitfähige Barrierewand eine Barrierewandöffnung (OP-P) aufweist; eine auf der leitfähigen Barrierewand angeordnete Barrierewand-Isolierschicht (IP); und ein auf der Barrierewand-Isolierschicht angeordnetes lichtemittierendes Element (ED), wobei das lichtemittierende Element eine erste Elektrode (AE) beinhaltet, die elektrisch mit dem Transistor verbunden ist, ein auf der ersten Elektrode angeordnetes Emissionsmuster (EP) und eine zweite auf dem Emissionsmuster angeordnete und elektrisch mit der leitfähigen Barrierewand verbundene Elektrode (CE).

2. Anzeigefeld nach Anspruch 1, wobei die leitfähige Barrierewand beinhaltet:
eine erste Barrierewandschicht, die auf der gemeinsamen Elektrode angeordnet ist; und
eine zweite Barrierewandschicht, die auf der ersten Barrierewandschicht angeordnet ist,
wobei die Barrierewandöffnung beinhaltet:
einen ersten Bereich, der durch die erste Barrierewandschicht definiert ist; und
einen zweiten Bereich, der durch die zweite Barrierewandschicht definiert ist und integral mit dem ersten Bereich gebildet wird, und
wobei der erste Bereich in einer ersten Richtung eine größere Länge aufweist als der zweite Bereich.

3. Anzeigefeld nach Anspruch 2, weiter umfassend:
eine auf der Barrierewand-Isolierschicht angeordnete Pixeldefinitionsschicht, wobei die Pixeldefinitionsschicht eine lichtemittierende Öffnung aufweist, die konfiguriert ist, um mindestens einen Abschnitt der ersten Elektrode freizulegen.

4. Anzeigefeld nach Anspruch 3, wobei die lichtemittierende Öffnung die Barrierewandöffnung nicht überlappt.

5. Anzeigefeld nach einem der Ansprüche 2 bis 4, wobei das Emissionsmuster eine Seitenoberfläche der zweiten Barrierewandschicht bedeckt und die zweite Elektrode eine obere Oberfläche des Emissionsmusters und mindestens einen Abschnitt einer Seitenoberfläche des Emissionsmusters bedeckt.

6. Anzeigefeld nach einem der Ansprüche 2 bis 5, weiter umfassend:
eine Hilfselektrode, die konfiguriert ist, um die zweite Elektrode und eine untere Oberfläche der zweiten Barrierewandschicht zu bedecken und direkten Kontakt mit der unteren Oberfläche der zweiten Barrierewandschicht aufbaut.

7. Anzeigefeld nach Anspruch 6, wobei:
(i) die Hilfselektrode Kontakt mit einer Seitenoberfläche der ersten Barrierewandschicht aufbaut; oder
(ii) das Anzeigefeld weiter umfasst:
eine Blind-Hilfselektrode, die von der Hilfselektrode beabstandet ist und konfiguriert ist, um Kontakt mit einer Seitenoberfläche der ersten Barrierewandschicht aufzubauen.

8. Verfahren nach Anspruch 6 oder Anspruch 7, weiter umfassend:
ein unteres anorganisches Verkapselungsmuster, das konfiguriert ist, um eine obere Oberfläche der Hilfselektrode zu bedecken, wobei das untere anorganische Verkapselungsmuster von der gemeinsamen Elektrode beabstandet ist.

9. Anzeigefeld nach einem der Ansprüche 1 bis 8, weiter umfassend:
ein lichtemittierendes Kontaktloch, das konfiguriert ist, um die leitfähige Barrierewand und die gemeinsame Elektrode zu durchdringen und die erste Elektrode zu überlappen, wenn sie von oberhalb einer Ebene betrachtet wird, wobei optional:
(i) die erste Elektrode einen kreisförmigen Teil und einen hervorstehenden Teil beinhaltet, der konfiguriert ist, um sich von einer Seite des kreisförmigen Teils zu erstrecken, wobei das lichtemittierende Kontaktloch den hervorstehenden Teil überlappt, wenn es von oberhalb der Ebene betrachtet wird; oder
(ii) die erste Elektrode einen kreisförmigen Teil beinhaltet, wobei das lichtemittierende Kontaktloch, wenn von oberhalb der Ebene betrachtet, einen Mittelpunkt des kreisförmigen Teils überlappt.

10. Anzeigefeld nach einem der Ansprüche 1 bis 9, wobei die erste Elektrode zwischen der zweiten Elektrode und der gemeinsamen Elektrode angeordnet ist.

11. Verfahren zum Herstellen eines Anzeigefeldes, wobei das Verfahren umfasst:
Bilden einer Schaltungselementschicht (DP-CL) und einer gemeinsamen Elektrode (BE) auf einer Basisschicht (BL), wobei die Schaltungselementschicht einen Transistor (TR1) beinhaltet; Bilden einer vorläufigen leitfähigen Barrierewand (PW-I) auf der gemeinsamen Elektrode; Bilden einer vorläufigen Barrierewand-Isolierschicht (IP-I), einer ersten Elektrode (AE) und einer vorläufigen Pixeldefinitionsschicht (PDL-I), die konfiguriert ist, um die erste Elektrode zu bedecken, auf der vorläufigen leitfähigen Barrierewand; Bilden einer lichtemittierenden Öffnung (OP-E), die konfiguriert ist, um die erste Elektrode zu überlappen, durch Ätzen der vorläufigen Pixeldefinitionsschicht; Bilden einer leitfähigen Barrierewand (PW), einer Barrierewand-Isolierschicht (IP) und einer Pixeldefinitionsschicht (PDL) durch Ätzen der vorläufigen leitfähigen Barrierewand, der vorläufigen Barrierewand-Isolierschicht und der vorläufigen Pixeldefinitionsschicht, wobei eine Barrierewandöffnung (OP-P) in der leitfähigen Barrierewand definiert ist; Bilden eines Emissionsmusters (EP), das konfiguriert ist, um die erste Elektrode zu bedecken, auf der leitfähigen Barrierewand; und Bilden einer zweiten Elektrode (CE), die elektrisch mit der leitfähigen Barrierewand verbunden ist, auf dem Emissionsmuster, wobei die lichtemittierende Öffnung und die Barrierewandöffnung, wenn von oberhalb einer Ebene betrachtet, einander nicht überlappen.

12. Verfahren nach Anspruch 11, wobei die vorläufige leitfähige Barrierewand beinhaltet:
eine erste vorläufige Barrierewandschicht, die auf der gemeinsamen Elektrode angeordnet ist; und
eine zweite vorläufige Barrierewandschicht, die auf der ersten vorläufigen Barrierewandschicht angeordnet ist, und
wobei das Bilden der leitfähigen Barrierewand, der Barrierewand-Isolierschicht und der Pixeldefinitionsschicht beinhaltet:
zunächst Ätzen der vorläufigen leitfähigen Barrierewand, der vorläufigen Barrierewand-Isolierschicht und der vorläufigen Pixeldefinitionsschicht; und
Bilden einer ersten Barrierewandschicht und einer zweiten Barrierewandschicht durch zweites Ätzen der ersten vorläufigen Barrierewandschicht.

13. Verfahren nach Anspruch 12, weiter umfassend:
Bilden einer Hilfselektrode, die konfiguriert ist, um die zweite Elektrode und eine untere Oberfläche der zweiten Barrierewandschicht zu bedecken.

14. Verfahren nach Anspruch 13, wobei:
(i) die Hilfselektrode in Kontakt mit einer Seitenoberfläche der ersten Barrierewandschicht steht; und/oder
(ii) das Verfahren weiter umfasst:
Bilden eines unteren anorganischen Verkapselungsmusters, das konfiguriert ist, um eine obere Oberfläche der Hilfselektrode zu bedecken,
wobei die unteren anorganischen Verkapselungsmuster von der gemeinsamen Elektrode beabstandet sind.

15. Verfahren nach einem der Ansprüche 11 bis 14, weiter umfassend:
Bilden eines lichtemittierenden Kontaktlochs durch Ätzen der vorläufigen leitfähigen Barrierenwand und der gemeinsamen Elektrode,
wobei die erste Elektrode und der Transistor über das lichtemittierende Kontaktloch elektrisch miteinander verbunden sind, wobei das Bilden der vorläufigen Barrierenwand-Isolierschicht, der ersten Elektrode und der vorläufigen Pixeldefinitionsschicht, die konfiguriert ist, um die erste Elektrode auf der vorläufigen leitfähigen Barrierenwand zu bedecken, optional beinhaltet:
Bilden der vorläufigen Barrierewand-Isolierschicht, die konfiguriert ist, um eine Innenoberfläche des lichtemittierenden Kontaktlochs zu bedecken.

## Revendications

1. Panneau d'affichage comprenant :
une couche de base (BL) ; un transistor (TR1) disposé sur la couche de base ; une électrode commune (BE) disposée sur le transistor; une paroi barrière conductrice (PW) disposée sur l'électrode commune, la paroi barrière conductrice présentant une ouverture de paroi barrière (OP-P) ; une couche isolante de paroi barrière (IP) disposée sur la paroi barrière conductrice ; et un élément d'émission de lumière (ED) disposé sur la couche isolante de paroi barrière, l'élément d'émission de lumière incluant une première électrode (AE) connectée électriquement au transistor, un motif d'émission (EP) disposé sur la première électrode et une seconde électrode (CE) disposée sur le motif d'émission et connectée électriquement à la paroi barrière conductrice.

2. Panneau d'affichage selon la revendication 1, dans lequel la paroi barrière conductrice inclut :
une première couche de paroi barrière disposée sur l'électrode commune ; et
une seconde couche de paroi barrière disposée sur la première couche de paroi barrière,
dans lequel l'ouverture de paroi barrière inclut :
une première région définie par la première couche de paroi barrière ; et
une seconde région définie par la seconde couche de paroi barrière et formée d'un seul tenant avec la première région, et
dans lequel la première région présente une longueur dans une première direction supérieure à la seconde région.

3. Panneau d'affichage selon la revendication 2, comprenant en outre :
une couche de définition de pixel disposée sur la couche isolante de paroi barrière, la couche de définition de pixel présentant une ouverture d'émission de lumière configurée pour exposer au moins une partie de la première électrode.

4. Panneau d'affichage selon la revendication 3, dans lequel l'ouverture d'émission de lumière ne chevauche pas l'ouverture de paroi barrière.

5. Panneau d'affichage selon l'une quelconque des revendications 2 à 4, dans lequel le motif d'émission couvre une surface latérale de la seconde couche de paroi barrière, et la seconde électrode couvre une surface supérieure du motif d'émission et au moins une partie d'une surface latérale du motif d'émission.

6. Panneau d'affichage selon l'une quelconque des revendications 2 à 5, comprenant en outre :
une électrode auxiliaire configurée pour couvrir la seconde électrode et une surface inférieure de la seconde couche de paroi barrière et pour établir un contact direct avec la surface inférieure de la seconde couche de paroi barrière.

7. Panneau d'affichage selon la revendication 6, dans lequel :
(i) l'électrode auxiliaire entre en contact avec une surface latérale de la première couche de paroi barrière ; ou
(ii) le panneau d'affichage comprend en outre :
une électrode auxiliaire factice espacée de l'électrode auxiliaire et configurée pour entrer en contact avec une surface latérale de la première couche de paroi barrière.

8. Panneau d'affichage selon la revendication 6 ou la revendication 7, comprenant en outre :
un motif d'encapsulation inorganique inférieur configuré pour recouvrir une surface supérieure de l'électrode auxiliaire, dans lequel le motif d'encapsulation inorganique inférieur est espacé de l'électrode commune.

9. Panneau d'affichage selon l'une quelconque des revendications 1 à 8, comprenant en outre :
un trou de contact d'émission de lumière configuré pour traverser la paroi barrière conductrice et l'électrode commune et chevaucher la première électrode lorsqu'il est vu de dessus, facultativement dans lequel :
(i) la première électrode inclut une partie circulaire et une partie faisant saillie configurée pour s'étendre d'un côté de la partie circulaire, dans lequel le trou de contact d'émission de lumière chevauche la partie faisant saillie lorsqu'il est vu de dessus ; ou
(ii) la première électrode inclut une partie circulaire, dans lequel le trou de contact d'émission de lumière chevauche un centre de la partie circulaire lorsqu'il est vu du dessus du plan.

10. Panneau d'affichage selon l'une quelconque des revendications 1 à 9, dans lequel la première électrode est disposée entre la seconde électrode et l'électrode commune.

11. Procédé de fabrication d'un panneau d'affichage, le procédé comprenant :
la formation d'une couche d'élément de circuit (DP-CL) et une électrode commune (BE) sur une couche de base (BL), la couche d'élément de circuit incluant un transistor (TR1) ; la formation d'une paroi barrière conductrice préliminaire (PW-I) sur l'électrode commune ; la formation, sur la paroi barrière conductrice préliminaire, d'une couche isolante de paroi barrière préliminaire (IP-I), d'une première électrode (AE) et d'une couche de définition de pixel préliminaire (PDL-I) configurée pour recouvrir la première électrode ; la formation d'une ouverture d'émission de lumière (OP-E) configurée pour chevaucher la première électrode, par gravure de la couche de définition de pixel préliminaire ; la formation d'une paroi barrière conductrice (PW), d'une couche isolante de paroi barrière (IP) et d'une couche de définition de pixel (PDL) par gravure de la paroi barrière conductrice préliminaire, la couche isolante de paroi barrière préliminaire et la couche de définition de pixel préliminaire, dans lequel une ouverture de paroi barrière (OP-P) est définie dans la paroi barrière conductrice ; la formation, sur la paroi barrière conductrice, d'un motif d'émission (EP) configuré pour recouvrir la première électrode ; et la formation, sur le motif d'émission, d'une seconde électrode (CE) électriquement connectée à la paroi barrière conductrice, dans lequel l'ouverture d'émission de lumière et l'ouverture de paroi barrière ne se chevauchent pas mutuellement lorsqu'elles sont vues du dessus d'un plan.

12. Procédé selon la revendication 11, dans lequel la paroi barrière conductrice préliminaire inclut :
une première couche de paroi barrière préliminaire disposée sur l'électrode commune ; et
une seconde couche de paroi barrière préliminaire disposée sur la première couche de paroi barrière préliminaire, et
dans lequel la formation de la paroi barrière conductrice, de la couche isolante de paroi barrière et de la couche de définition de pixel inclut :
premièrement, la gravure de la paroi barrière conductrice préliminaire, de la couche isolante de paroi barrière préliminaire et de la couche de définition de pixel préliminaire ; et
la formation d'une première couche de paroi barrière et d'une seconde couche de paroi barrière en gravant une seconde fois la première couche de paroi barrière préliminaire.

13. Procédé selon la revendication 12, comprenant en outre :
la formation d'une électrode auxiliaire configurée pour recouvrir la seconde électrode et une surface inférieure de la seconde couche de paroi barrière.

14. Procédé selon la revendication 13, dans lequel :
(i) l'électrode auxiliaire est en contact avec une surface latérale de la première couche de paroi barrière ; et/ou
(ii) le procédé comprend en outre :
la formation d'un motif d'encapsulation inorganique inférieur configuré pour recouvrir une surface supérieure de l'électrode auxiliaire,
dans lequel les motifs d'encapsulation inorganiques inférieurs sont espacés de l'électrode commune.

15. Procédé selon l'une quelconque des revendications 11 à 14, comprenant en outre :
la formation d'un trou de contact d'émission de lumière en gravant la paroi barrière conductrice préliminaire et l'électrode commune,
dans lequel la première électrode et le transistor sont connectés électriquement mutuellement par l'intermédiaire du trou de contact d'émission de lumière, et, facultativement, former la couche isolante de paroi barrière préliminaire, la première électrode et la couche préliminaire de définition de pixel configurée pour recouvrir la première électrode sur la paroi barrière conductrice préliminaire inclut :
la formation de la couche isolante de paroi barrière préliminaire configurée pour recouvrir une surface intérieure du trou de contact d'émission de lumière.
